(19) 

**Europäisches Patentamt**
**European Patent Office**
**Office européen des brevets**

(11)  **EP 4 722 175 A1**

(12)  **EUROPEAN PATENT APPLICATION**
published in accordance with Art. 153(4) EPC

(43) Date of publication:
08.04.2026  Bulletin 2026/15

(21) Application number: 24815552.5

(22) Date of filing: 30.05.2024

(51) International Patent Classification (IPC):
$C03C\ 17/34^{(2006.01)}$   $B32B\ 7/023^{(2019.01)}$
$C03C\ 21/00^{(2006.01)}$   $G02B\ 1/18^{(2015.01)}$
$G02B\ 1/115^{(2015.01)}$   $G02B\ 5/02^{(2006.01)}$

(52) Cooperative Patent Classification (CPC):
B32B 7/023; C03C 17/34; C03C 21/00;
G02B 1/115; G02B 1/18; G02B 5/02

(86) International application number:
PCT/JP2024/019817

(87) International publication number:
WO 2024/248071 (05.12.2024 Gazette 2024/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.06.2023  JP 2023091871

(71) Applicant: AGC Inc.
Chiyoda-ku
Tokyo 100-8405 (JP)

(72) Inventors:
• TAKEMOTO, Kazuya
  Tokyo 100-8405 (JP)
• KAWAI, Keisuke
  Tokyo 100-8405 (JP)
• TAKAHOSHI, Hideaki
  Tokyo 100-8405 (JP)
• FUJIWARA, Teruo
  Tokyo 100-8405 (JP)
• ZUKERAN, Tomohiro
  Tokyo 100-8405 (JP)

(74) Representative: Müller-Boré & Partner
Patentanwälte PartG mbB
Friedenheimer Brücke 21
80639 München (DE)

(54)  **ANTI-REFLECTION FILM-PROVIDED TRANSPARENT SUBSTRATE AND IMAGE DISPLAY DEVICE**

(57)  The present invention pertains to an anti-reflection film-provided transparent substrate that has a transparent substrate having two main surfaces, and has, on one of the two main surfaces of the transparent substrate, a diffusion layer and an anti-reflection film in the stated order from the transparent substrate side. When source light is incident on the one of the two main surfaces at an incidence angle of 45° in a state where reflection on the other main surface of the transparent substrate is eliminated, a* and b* at a D65 source light of diffused reflected light at angles of -15°, 15°, 25°, 45°, 75°, and 110° with respect to specularly reflected light satisfy formulae (1) and (2).

$$(1):\ -2 \leq a^* \leq 4.5$$

$$(2):\ -5 \leq b^* \leq 10$$

FIG. 1

**Description**

TECHNICAL FIELD

The present invention relates to an anti-reflection film-attached transparent substrate and an image display device including the same.

BACKGROUND ART

In recent years, from the viewpoint of aesthetic appearance, a method of installing a transparent substrate such as a cover glass on the front surface of an image display device such as a liquid crystal display (LCD) has been used. In order to prevent reflection of external light on such a transparent substrate, a transparent substrate including an anti-reflection film (hereinafter, also referred to as an anti-reflection film-attached transparent substrate) is known. For example, Patent Document 1 discloses an anti-reflection film-attached transparent substrate having a light absorption ability and an insulating property.

It is also known to provide a diffusion layer on a transparent substrate in order to prevent reflection of external light. The diffusion layer suppresses reflection of external light by diffusing incident light. However, in a case where the transparent substrate includes a diffusion layer and is used in an image display device, a screen may appear whitish due to diffused light when turned off. Therefore, by further providing the anti-reflection film as described above on the diffusion layer, reflection of incident light can be suppressed, and whiteness can be reduced. Accordingly, it is possible to improve the blackened texture when the screen is turned off while suitably suppressing reflection.

As an image display device, a μ-LED display using a μ-LED element as a light source has recently attracted attention. Among them, a large μ-LED display is manufactured by arranging and connecting (tiling), for example, about 200 small LED panels having about A5 size (148 mm × 210 mm) without a gap.

CITATION LIST

PATENT LITERATURE

Patent Literature 1: JP2018 -115105A

SUMMARY OF INVENTION

TECHNICAL PROBLEM

Since the anti-reflection film as disclosed in Patent Document 1 uses optical interference, an optical path length changes depending on an incident angle or an emission angle of light, and a reflection color (color tone) may change variously. In particular, in the case of a configuration in which an anti-reflection film is provided on the diffusion layer, since light is easily diffused and reflected by the diffusion layer, a change in color tone due to an angle tends to be relatively significant. When a plurality of LED panels are tiled, for example, in the case of manufacturing a large μ-LED display, if the diffusion reflection color (color tone of the diffusely reflected light) is different for each panel, the appearance becomes various colors particularly during turning-off, and the quality may be significantly degraded.

Therefore, an object of the present invention is to provide an anti-reflection film-attached transparent substrate in which a color deviation is less noticeable even after tiled, and an image display device including the same.

SOLUTION TO PROBLEM

The present inventors have experimentally found that, when light is incident on an anti-reflection film-attached transparent substrate at a predetermined angle, a* and b* of diffusely reflected light at various angles satisfy predetermined requirements, whereby an anti-reflection film-attached transparent substrate in which a color deviation is less noticeable even after tiled is obtained, and have completed the present invention.

That is, a first aspect of the present invention relates to an anti-reflection film-attached transparent substrate including a transparent substrate having two main surfaces and a diffusion layer and an anti-reflection film in this order from the transparent substrate side on one main surface of the transparent substrate, in which when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1) and (2).

$$(1) \ -2 \leq a^* \leq 4.5$$

$$(2) \ -5 \leq b^* \leq 10$$

Further, a second aspect of the present invention relates to an anti-reflection film-attached transparent substrate including a transparent substrate having two main surfaces and a diffusion layer and an anti-reflection film in this order from the transparent substrate side on one main surface of the transparent substrate, in which when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1') and (2').

$$(1') \ -2 \leq a^* \leq 4.5$$

$$(2') \ -3 \leq b^* \leq 13$$

ADVANTAGEOUS EFFECTS OF INVENTION

According to the first aspect and the second aspect of the present invention, it is possible to provide an anti-reflection film-attached transparent substrate in which color deviation is less noticeable even after tiled, and an image display device including the same. Since the color deviation is less noticeable when tiling is performed, the quality and aesthetic appearance of the anti-reflection film-attached transparent substrate and the image display device including the same can be improved.

BRIEF DESCRIPTION OF DRAWINGS

FIG. 1 is a cross-sectional view schematically showing a configuration example of an anti-reflection film-attached transparent substrate according to an embodiment of the present invention.
FIG. 2 is a schematic diagram illustrating a method of measuring a* and b* of diffusely reflected light at each angle.
FIG. 3 shows the measurement results of a* and b* of diffusely reflected light at each angle in Example 1.
FIG. 4 shows the measurement results of a* and b* of diffusely reflected light at each angle in Example 2.
FIG. 5 shows the measurement results of a* and b* of diffusely reflected light at each angle in Example 3.
FIG. 6 shows the measurement results of a* and b* of diffusely reflected light at each angle in Example 4.
FIG. 7 shows the measurement results of a* and b* of diffusely reflected light at each angle in Example 5.
FIG. 8 shows the measurement results of a* and b* of diffusely reflected light at each angle in Example 6.
FIG. 9 shows the measurement results of a* and b* of diffusely reflected light at each angle in Example 7.
FIG. 10 shows the measurement results of a* and b* of diffusely reflected light at each angle in Example 8.
FIG. 11 shows the measurement results of a* and b* of diffusely reflected light at each angle in Example 9.
FIG. 12 shows the measurement results of a* and b* of diffusely reflected light at each angle in Example 10.
FIG. 13 shows the measurement results of a* and b* of diffusely reflected light at each angle in Example 11.
FIG. 14 shows the measurement results of a* and b* of SCI in each example.

DESCRIPTION OF EMBODIMENTS

Hereinafter, the present invention will be described in detail, but the present invention is not limited to the following embodiments, and can be arbitrarily modified and implemented without departing from the gist of the present invention. In addition, "to" indicating a numerical range is used in a meaning including numerical values described before and after the numerical range as a lower limit value and an upper limit value.

In the present specification, the expression "having another layer, film, or the like on the main surface of a substrate such as a transparent substrate, on a layer such as a diffusion layer, or on a film such as an anti-reflection film" is not limited to an aspect in which the another layer, film, or the like is provided in contact with the main surface, layer, or film, and may be an aspect in which a layer, film, or the like is provided in an upper direction thereof. For example, the phrase "having a diffusion layer on the main surface of the transparent substrate" means that the diffusion layer may be provided so as to be in contact with the main surface of the transparent substrate, or any other layer or film may be provided between the transparent substrate and the diffusion layer.

<Anti-reflection Film-attached Transparent Substrate>

An anti-reflection film-attached transparent substrate according to a first embodiment of the present invention includes a transparent substrate having two main surfaces, and a diffusion layer and an anti-reflection film in this order from the transparent substrate side on one main surface of the transparent substrate, in which when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1) and (2).

$$(1) \ -2 \leq a^* \leq 4.5$$

$$(2) \ -5 \leq b^* \leq 10$$

An anti-reflection film-attached transparent substrate according to a second embodiment of the present invention includes a transparent substrate having two main surfaces, and a diffusion layer and an anti-reflection film in this order from the transparent substrate side on one main surface of the transparent substrate, in which when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1') and (2').

$$(1') \ -2 \leq a^* \leq 4.5$$

$$(2') \ -3 \leq b^* \leq 13$$

The anti-reflection film-attached transparent substrate according to the first embodiment of the present invention and the anti-reflection film-attached transparent substrate according to the second embodiment of the present invention are collectively referred to as "anti-reflection film-attached transparent substrate according to the embodiment of the present invention".

(Antireflection Film-attached Transparent Substrate)

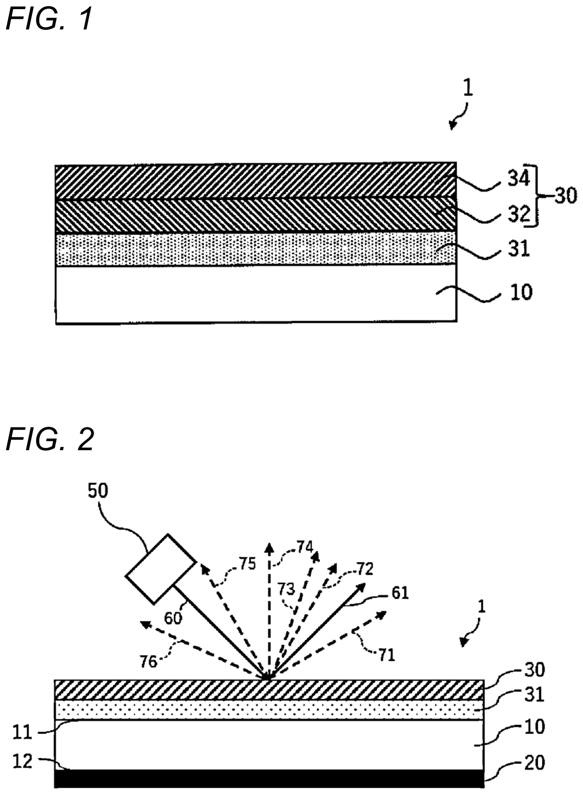

FIG. 1 is a cross-sectional view schematically showing a configuration example of an anti-reflection film-attached transparent substrate according to an embodiment of the present invention. The anti-reflection film-attached transparent substrate 1 illustrated in FIG. 1 includes a transparent substrate 10, a diffusion layer 31, and an anti-reflection film 30. In FIG. 1, a diffusion layer 31 is formed on one main surface of a transparent substrate 10, and an anti-reflection film 30 is formed on the diffusion layer 31. The anti-reflection film is, for example, a multilayer film having a laminated structure in which at least two dielectric layers having different refractive indices are laminated. In FIG. 1, the anti-reflection film 30 is a multilayer film in which a first dielectric layer 32 and a second dielectric layer 34 are laminated. Although FIG. 1 illustrates a configuration in which the diffusion layer 31 is further formed on the transparent substrate 10, the diffusion layer may be formed on the surface layer of the transparent substrate itself by a method of performing a surface treatment on the transparent substrate as described later.

The anti-reflection film-attached transparent substrate according to the embodiment of the present invention has a diffusion layer and an anti-reflection film in this order from the transparent substrate side on one main surface of the transparent substrate. Accordingly, it is possible to obtain an anti-reflection film-attached transparent substrate in which reflection of external light can be suppressed, whiteness due to diffusely reflected light is suppressed, and a bluish (front view) and yellowish (oblique view) texture is excellent depending on a viewing angle.

(a* and b* of diffusely reflected light)

In the anti-reflection film-attached transparent substrate according to the embodiment of the present invention, when a light source is incident on one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy predetermined requirements.

In the present specification, the diffusely reflected light at each angle of -15°, 15°, 25°, 45°, 75°, and 110° obtained by the above method may be referred to as "diffusely reflected light at each angle". In addition, "diffusely reflected light at 15°'" means diffusely reflected light at 15° of "diffusely reflected light at each angle", and the same applies to a case where the angles are different. In addition, unless otherwise specified, a\*, b\*, and L\* of the diffusely reflected light respectively mean a\*, b\*, and L\* of the diffusely reflected light under the D65 light source.

FIG. 2 is a schematic view illustrating a method for measuring a\* and b\* of diffusely reflected light at each angle. In the anti-reflection film-attached transparent substrate 1 shown in FIG. 2, the transparent substrate 10 includes one main surface 11 and the other main surface 12. A diffusion layer 31 and an anti-reflection film 30 are formed on the one main surface 11. In the measurement method illustrated in FIG. 2, the anti-reflection film-attached transparent substrate 1 is in a state where reflection on the other main surface is removed by attaching the black tape 20 to the other main surface 12. Light is incident from the light source 50 on the one main surface 11 side of the anti-reflection film-attached transparent substrate 1 at an incident angle of 45°. As the incident light source, a light source that emits light in the entire visible light range is used. As such a light source, for example, a white light source such as a high color rendering white LED is preferably used. With the specularly reflected light 61 of the incident light 60 as a reference (0°), the diffusely reflected lights 71, 72, 73, 74, 75, and 76 are diffusely reflected lights at -15°, 15°, 25°, 45°, 75°, and 110°, respectively. Here, assuming that the specularly reflected light 61 is 0°, the direction in which the angle increases toward the side where the incident light 60 is present is the + direction, and the direction in which the angle increases toward the side opposite to the incident light 60 is the - direction. For the diffusely reflected light at each angle, the reflectance at the visible light wavelength is measured, and L\*, a\* and b\* under the D65 light source are calculated. This measurement can be performed using, for example, CM-M6 manufactured by Konica Minolta, Inc.

As a method of removing the reflection on the other main surface, for example, a method of bonding a black tape to the other main surface is exemplified as illustrated in FIG. 2. It is preferable to use a black tape that is substantially free of a diffuse reflection component. The presence or absence of the diffuse reflection component in the black tape can be evaluated, for example, by attaching a black tape for which the presence or absence of the diffuse reflection component is to be evaluated to a transparent material having almost no diffuse reflection component, such as a float glass, and measuring SCE Y as the diffuse reflection component from the glass surface. Here, "substantially free of a diffuse reflection component" means that the SCE Y is 0.02% or less. The SCE Y is measured using a spectrophotometer according to the method specified in JIS Z 8722 (2009). It is necessary to designate a light source for the calculation of SCE Y, and it is preferable to use a D65 light source for the calculation because the present invention assumes suppression of reflection in a bright place in the daytime.

Examples of the black tape used for removing reflection on the other main surface include "KUKKIRI MIERU" manufactured by TOMOEGAWA CORPORATION. Since "KUKKIRI MIERU" contains substantially no diffuse reflection component (the diffusion reflectance corresponds to approximately 0.01% in SCE Y with a D65 light source), the diffusion reflectance of the black tape itself is low, and the diffusion reflectance measurement of the surface of the transparent substrate provided with the anti-reflection film is less affected.

As a result of intensive studies, the present inventors have experimentally found that, when a\* and b\* of diffusely reflected light at each angle satisfy a predetermined requirement, an anti-reflection film-attached transparent substrate in which a color deviation is less noticeable even after tiled is obtained, and have completed the present invention. That is, the fact that a\* and b\* of the reflected light at each angle are different from each other means that the color tone changes depending on the angle at which such an anti-reflection film-attached transparent substrate is viewed. As described above, the change in color tone depending on the viewing angle can generally cause the color deviation to be conspicuous after tiling. This is because, for example, when a display in which a plurality of panels are tiled is viewed from one point, an angle formed by a line of sight and each panel constituting the display varies. This tendency can be more remarkable as the area of the display is larger.

On the other hand, the present invention has found that when a\* and b\* of diffusely reflected light at each angle satisfy a predetermined requirement, a change in color tone when the angle is changed is less noticeable. The reason for this is presumed as follows. That is, when a\* and b\* of the diffusely reflected light at each angle satisfy the above expressions (1) and (2), or when a\* and b\* satisfy the above expressions (1') and (2'), the color tone changes substantially between blue (front view) and yellow (oblique view) depending on the viewing angle. Within these color ranges, even if a\* and b\* change depending on the angle, it is presumed that the difference is hardly perceived and the color deviation is particularly less noticeable. This effect is such that the color deviation is particularly less noticeable than in the case where the color tone of the diffusely reflected light changes between colorless or light yellow to light green. Green is visible light having a wavelength of 500 nm to 550 nm, which is particularly highly sensitive to human eyes, and tends to sensitively sense a color difference even with a slight change in green. In addition, it is considered that by setting the region in which a\* and b\* can change to a limited range, the magnitude of the change in color tone due to the angle becomes relatively small, and thus the color deviation becomes less noticeable. Furthermore, by satisfying the above expressions (1) and (2) or the above expressions (1') and (2'), the color difference between the two adjacent anti-reflection film-attached transparent substrates when tiled is limited, and the effect of making the joint between the plurality of substrates less noticeable can also be expected.

In the first embodiment of the present invention, a* of the diffusely reflected light at each angle is -2≤a*≤4.5. a* is -2 or more, preferably -1.5 or more, more preferably -1.0 or more, still more preferably -0.5 or more, and particularly preferably -0.3 or more, from the viewpoint of reducing greenish tone when the display is turned off to improve the blackness. a* is 4.5 or less, preferably 4.0 or less, and more preferably 3.0 or less from the viewpoint of reducing redness and improving blackness.

In the first embodiment of the present invention, b* of the diffusely reflected light at each angle is -5≤b*≤10. b* is -5 or more, preferably -4 or more, more preferably -3 or more, still more preferably -2 or more, and particularly preferably -1 or more, from the viewpoint of reducing bluish color tone when the display is turned off to improve the blackness. b* is 10 or less, preferably 9 or less, particularly preferably 8 or less, and further preferably 7 or less, from the viewpoint of reducing yellowness and improving blackness.

In the second embodiment of the present invention, a* of the diffusely reflected light at each angle is -2≤a*≤4.5. a* is -2 or more, preferably -1.5 or more, more preferably -1.0 or more, still more preferably -0.5 or more, and particularly preferably -0.3 or more, from the viewpoint of reducing greenish tone when the display is turned off to improve the blackness. a* is 4.5 or less, preferably 4.0 or less, and more preferably 3.0 or less from the viewpoint of reducing redness and improving blackness.

In the second embodiment of the present invention, b* of the diffusely reflected light at each angle is -3≤b*≤13. b* is -3 or more, preferably -2 or more, and particularly preferably - 1 or more, from the viewpoint of reducing bluish tone when the display is turned off to improve the blackness. b* is 13 or less, preferably 10 or less, more preferably 9 or less, and particularly preferably 8 or less from the viewpoint of reducing yellowness and improving blackness.

In the embodiment of the present invention, the absolute value of the slope of the approximate straight line calculated from the a*b* coordinates of the diffusely reflected light at each angle is preferably 2 or more. When the absolute value of the slope is 2 or more, even if the color tone changes depending on the angle, the change in a* is relatively small, and b* mainly changes depending on the angle. With such a change manner, the change in the color tone due to the angle is likely to be limited, for example, to change between colorless and a predetermined one color, and the color tone is prevented from changing variously depending on the angle, so that the reflection color change from green to red, which is likely to cause discomfort to humans, is less likely to occur. In this case, even if a* and b* change depending on the angle, it is presumed that the difference is hardly perceived and the color deviation is less noticeable.

The absolute value of the slope is preferably 2.5 or more, and more preferably 3 or more, from the viewpoint of suppressing the color change from green to red. The upper limit of the absolute value of the slope is not particularly limited, and the approximate straight line may have a constant a*. Specifically, the approximate straight line is calculated by linear approximation from a*b* coordinates of the diffusely reflected light at each angle. That is, a*b* of diffusely reflected light at -15°, 15°, 25°, 45°, 75°, and 110° is plotted on an xy coordinate plane (a*b* coordinate plane) in which a* is an x axis and b* is a y axis, and y (b*) is linearly approximated as a linear expression of x (a*) from these six points by a least square method to obtain an approximate straight line. For example, an approximate straight line may be obtained by linear approximation using an "approximate curve" function of spreadsheet software "Microsoft Excel" (registered trademark) manufactured by Microsoft Corporation.


(L* of Diffusely Reflected Light)

Among the diffusely reflected light at each angle of -15°, 15°, 25°, 45°, 75°, and 110°, the diffusely reflected light at an angle close to the specularly reflected light of the incident light, for example, the diffusely reflected light at -15°, 15°, and 25° tends to have a higher brightness (L*) than the diffusely reflected light at 45°, 75°, and 110°. The color of the diffusely reflected light having high brightness is likely to be perceived more strongly than the color of the diffusely reflected light not having high brightness. From such a viewpoint, it is preferable that a* and b* of the diffusely reflected light at -15°, 15°, and 25° are values close to zero, or L* is a smaller value, and in particular, it is preferable that a* which is an index of green is close to zero or positive from the viewpoint of sensitivity of human eyes. As a result, since the color tone of light having an angle that is more likely to be perceived among the diffusely reflected light is appropriately controlled, the color deviation can be made less noticeable.

L* of the diffusely reflected light at -15° under the D65 light source is preferably 20 to 60, and more preferably 22 to 55. When L* of the diffusely reflected light of -15° is in this range, the anti-reflection film-attached transparent substrate has appropriate light diffusibility (antiglare property) or low reflectivity, and reflection of external light can be suitably suppressed.

L* of the diffusely reflected light at 15° under the D65 light source is preferably 5 to 35, and more preferably 6 to 30. When the L* of the diffusely reflected light of 15° is in this range, the anti-reflection film-attached transparent substrate has appropriate light diffusibility (antiglare property) or low reflectivity, and reflection of external light can be suitably suppressed.

L* of the diffusely reflected light at 25° under the D65 light source is preferably 0 to 20, and more preferably 0 to 15. When L* of the diffusely reflected light of 25° is in this range, the anti-reflection film-attached transparent substrate can have low reflectivity.

It is preferable that L* of the diffusely reflected light at -15° under the D65 light source is 20 to 60, L* of the diffusely reflected light at 15° is 5 to 35, and L* of the diffusely reflected light at 25° is 0 to 20. According to this, the anti-reflection film-attached transparent substrate has more appropriate light diffusibility (antiglare property) or low reflectivity, and reflection of external light can be suitably suppressed. L* of the diffusely reflected light at each angle is measured and calculated by the same method as a* and b* using, for example, CM-M6 manufactured by Konica Minolta, Inc.

(Luminous Reflectance (SCI Y) and Reflection Color (SCI a*, b*))

In the anti-reflection film-attached transparent substrate according to the embodiment of the present invention, the luminous reflectance (SCI Y) of the outermost surface is preferably 1.2% or less. When the luminous reflectance (SCI Y) is within the above range, the effect of preventing reflection of external light on the screen is high when used in an image display device. The luminous reflectance (SCI Y) is more preferably 1.0% or less, still more preferably 0.9% or less, still more preferably 0.8% or less, and particularly preferably 0.7% or less.

The luminous reflectance (SCI Y) can be reduced by adjusting the balance of the film thicknesses between the high refractive index layer and the low refractive index layer to generate optical interference and suppress reflected light.

The luminous reflectance (SCI Y) and the reflection color (SCI a* b* described later can be measured using a spectrophotometer (manufactured by Konica Minolta, Inc., trade name: CM-26d) by a method specified in JIS Z 8722 (2009). The light source used for the calculation is preferably a D65 light source in consideration of the possibility of being used in a bright place such as sunlight. The luminous reflectance (SCI Y) of the outermost surface can be measured in a state where back surface reflection is removed by attaching a black tape to the other main surface (hereinafter, also referred to as a back surface of the transparent substrate or simply a back surface), which is not the main surface on the anti-reflection film side, of the two main surfaces of the transparent substrate. In evaluating the reflectance of the outermost surface, a black material for removing back surface reflection is a very important factor. It is necessary to eliminate the interface between the air and the main surface by adhering the black material to the main surface, and a black tape or a black paint is generally used. Further, in order to accurately evaluate the SCI reflectance of the outermost surface, it is necessary to use a black material having almost no diffuse reflection component. For example, in the case of using a black tape, a black vinyl tape (trade name: 117) of 3M Company or the like has a diffuse reflection component of about 0.7%, and thus is unsuitable for the evaluation of the present case. On the other hand, as described above, a black tape (trade name: KUKKIRI MIERU) manufactured by TOMOEGAWA CORPORATION. has a diffuse reflection component of about 0%, and is preferable for measurement in a state where back surface reflection is removed as in the present case. As the black paint, a black light shielding film is generally printed on the back surface portion of the display front surface cover for the purpose of hiding the wiring on the outer peripheral portion of the screen from the viewer, and examples thereof include those manufactured by Teikoku Printing Inks Mfg. Co., Ltd. and those manufactured by Jujo Chemical Co., Ltd. Such a black light-shielding film for a display is often a polyester-based ink into which a black pigment is mixed from the viewpoint of light resistance, and the diffusion reflectance derived from the pigment is 0.2% to 0.3%, which is unsuitable for the important evaluation of the SCI reflectance of the outermost surface as in the present case.

In the anti-reflection film-attached transparent substrate according to the embodiment of the present invention, a* and b* of SCI of the outermost surface preferably satisfy the following expressions (3) and (4).

$$(3)\ -1 \leq a^* \leq 2$$

$$(4)\ -5 \leq b^* \leq 0$$

The a* of SCI on the outermost surface of the anti-reflection film-attached transparent substrate is preferably -1 or more, more preferably -0.8 or more, still more preferably -0.5 or more, and particularly preferably -0.3 or more, from the viewpoint of reducing greenish tone and improving blackness. a* of the SCI is preferably 2 or less, more preferably 1.8 or less, still more preferably 1.5 or less, and particularly preferably 1.0 or less from the viewpoint of reducing redness and improving blackness.

b* of SCI on the outermost surface of the anti-reflection film-attached transparent substrate is preferably -5 or more, more preferably -4 or more, still more preferably -3 or more, and particularly preferably -2 or more, from the viewpoint of reducing bluish tone and improving blackness. b* of the SCI is preferably 0 or less, more preferably -0.5 or less, still more preferably -1.0 or less, and particularly preferably -1.5 or less from the viewpoint of setting the diffusion reflection color within the range of the present invention.

As described above, a* and b* of SCI on the outermost surface of the anti-reflection film-attached transparent substrate can be measured using a spectrophotometer (manufactured by Konica Minolta, Inc., trade name: CM-26d) by a method specified in JIS Z 8722 (2009).

(Haze Value)

In the anti-reflection film-attached transparent substrate according to the embodiment of the present invention, the haze value is preferably 25% or more, preferably 30% or more, more preferably 40% or more, and still more preferably 50% or more from the viewpoint of suitably preventing reflection. The haze value is preferably, for example, 90% or less from the viewpoint of improving sharpness of an image when used in an image display device.

The anti-reflection film-attached transparent substrate having a relatively high haze value as described above is suitably used for, for example, a large $\mu$-LED display. The first reason is that, when the display is large, reflection of illumination and external light is more likely to occur, and thus it is required to more suitably prevent the reflection. Second, since the pitch of pixels is relatively large in a large $\mu$-LED display, even if the haze value is relatively high, a high-definition display is likely to be obtained. However, in such an anti-reflection film-attached transparent substrate having a relatively high haze value, since the amount of components that are diffusely reflected increases, the change in color tone due to the angle of diffusely reflected light tends to be particularly significant. In contrast, according to the present invention, even when the haze value is relatively high, the color deviation after tiling can be suitably suppressed.

In applications such as LCD displays, for example, an anti-reflection film-attached transparent substrate having a haze value of about 0% to 25% is suitably used. As long as the effects of the present invention can be obtained, there is no restriction against the haze value being, for example, 25% or less or less than 25% depending on the application.

The haze value can be adjusted by, for example, the surface shape of the diffusion layer. The haze value is measured using a haze meter (HZ-V3, manufactured by Suga Test Instruments Co., Ltd.) according to JIS K 7136:2000.

(Luminous Transmittance: Y)

The anti-reflection film-attached transparent substrate of the present aspect preferably has a luminous transmittance (Y) of 20% to 96%. When the luminous transmittance (Y) falls within the above range, it has an appropriate light absorption ability, and therefore, when used as a cover glass of an image display device, reflection of light can be suppressed. This improves the bright contrast of the image display device. The luminous transmittance (Y) is more preferably 50% to 90%, and still more preferably 60% to 90%. In particular, for example, when it is desired to keep the luminance of the display high, an anti-reflection film which does not have a light absorption ability or has relatively high transmittance and has a luminous transmittance of 90% or more as the anti-reflection film-attached transparent substrate is preferably used. The luminous transmittance (Y) in this case may be 90% to 96%, and is preferably 93% to 96%.

The luminous transmittance (Y) can be measured by a method specified in JIS Z 8701 (1999), as described in Examples described later.

In the anti-reflection film-attached transparent substrate of the present aspect, in order to set the luminous transmittance (Y) to 20% to 96%, for example, it is preferable to mainly use, as the first dielectric layer of the anti-reflection film, a mixed oxide of an oxide containing at least one selected from the group A consisting of Mo and W and an oxide containing at least one selected from the group B consisting of Si, Nb, Ti, Zr, Ta, Al, Sn, and In to adjust the oxidation amount of the film. However, for example, when it is desired to keep the luminance of the display high, an anti-reflection film which does not have light absorption ability or has relatively high transmittance and has a luminous transmittance of 90% or more as the anti-reflection film-attached transparent substrate may be suitably used. In this case, for example, an oxide containing at least one selected from Nb, Ti, Zr, Ta, Al, Sn, Mo, W, and In can be used as the first dielectric layer.

The luminous transmittance (Y) of the anti-reflection film-attached transparent substrate of the present aspect can be adjusted, for example, by controlling the irradiation time of the oxidation source, the irradiation output, the distance to the substrate, and the amount of oxidizing gas at the time of forming the first dielectric layer which is a high refractive index layer in the anti-reflection film described above.

(Sheet Resistance)

In the anti-reflection film-attached transparent substrate of the present aspect, the sheet resistance of the anti-reflection film is preferably $10^4\ \Omega/\square$ or more. When the sheet resistance of the anti-reflection film is within the above range, the anti-reflection film is insulating, and therefore in the case where the anti-reflection film is used as a cover glass of an image display device, even if a touch panel is provided, a change in capacitance due to contact of a finger necessary for the capacitive touch sensor is maintained, and the touch panel can function. The sheet resistance is more preferably $10^6\ \Omega/\square$ or more, and still more preferably $10^8\ \Omega/\square$ or more.

The sheet resistance can be measured by a method specified in JIS K 6911 (2006), as described in Examples below.

In order to set the sheet resistance of the anti-reflection film to $10^4\ \Omega/\square$ or more in the anti-reflection film-attached transparent substrate of this aspect, for example, the metal content in the anti-reflection film, the irradiation time of the oxidation source, the irradiation output, and the amount of oxidizing gas are adjusted.

(b* Value of Transmission Color Under D65 Light Source)

In the anti-reflection film-attached transparent substrate of the present aspect, the b* value of a transmission color under a D65 light source is preferably 5 or less. When the b* value is in the range described above, the transmitted light is not yellowish, and thus is suitable for use as a cover glass of an image display device. The b* value is more preferably 3 or less, and still more preferably 2 or less. The lower limit of the b* value is preferably -6 or more, more preferably -4 or more. When the b* value is in the above range, the transmitted light becomes colorless and does not inhibit the transmitted light, which is preferable.

The b* value of a transmission color under a D65 light source can be measured by a method specified in JIS Z 8729 (2004).

(Transparent Substrate)

In the present aspect, the transparent substrate having two main surfaces (hereinafter, also simply referred to as a transparent substrate) preferably has a refractive index of 1.4 or more and 1.7 or less. When the refractive index of the transparent substrate falls within the above range, reflection on the bonding surface can be sufficiently suppressed when a display, a touch panel, or the like is optically bonded. The refractive index is more preferably 1.45 or more, further preferably 1.47 or more, and more preferably 1.65 or less, further preferably 1.6 or less.

The transparent substrate preferably includes at least one of a glass and a resin. More preferably, the transparent substrate includes both a glass and a resin. When the transparent substrate includes a glass, the strength, flatness, and durability of the anti-reflection film-attached transparent substrate can be made excellent. In addition, a diffusion layer is easily formed by bonding a laminate formed of a resin substrate and an antiglare layer described later onto a glass substrate. In the anti-reflection film-attached transparent substrate on which the diffusion layer is formed by this method, the transparent substrate includes both a glass and a resin.

When the transparent substrate includes a glass, the type of the glass is not particularly limited, and glasses having various compositions can be used. Among them, the glass preferably contains sodium, and preferably has a composition that allows molding and strengthening by a chemical strengthening treatment. Specific examples of the glass include an aluminosilicate glass, a soda lime glass, a borosilicate glass, a lead glass, an alkali barium glass, and an aluminoborosilicate glass.

In the present specification, when the transparent substrate contains a glass, the transparent substrate is also referred to as a glass substrate.

The thickness of the glass substrate is not particularly limited, but when the glass is subjected to a chemical strengthening treatment, the thickness is, for example, preferably 5 mm or less, more preferably 3 mm or less, and still more preferably 1.5 mm or less in order to effectively perform the chemical strengthening. The thickness is, for example, 0.2 mm or more.

The glass substrate is preferably a chemically strengthened glass obtained by chemical strengthening. This increases the strength of the anti-reflection film-attached transparent substrate. When the glass substrate is subjected to the antiglare treatment described later, the chemical strengthening is preferably performed after the antiglare treatment and before the anti-reflection film (multilayer film) is formed.

When the transparent substrate includes a resin, the type of the resin is not particularly limited, and resins having various compositions can be used. Among these, the resin is preferably a thermoplastic resin or a thermosetting resin, and examples thereof include a polyvinyl chloride resin, a polyethylene resin, a polypropylene resin, a polystyrene resin, a polyvinyl acetate resin, a polyester resin, a polyurethane resin, a cellulose-based resin, an acrylic resin, an AS (acrylonitrile-styrene) resin, an ABS (acrylonitrile-butadiene-styrene) resin, a fluorine-based resin, a thermoplastic elastomer, a polyamide resin, a polyimide resin, a polyacetal resin, a polycarbonate resin, a modified polyphenylene ether resin, a polyethylene terephthalate resin, a polybutylene terephthalate resin, a polylactic acid-based resin, a cyclic polyolefin resin, and a polyphenylene sulfide resin. Among these, a cellulose-based resin is preferable, and examples thereof include a triacetyl cellulose resin, a polycarbonate resin, and a polyethylene terephthalate resin. These resins may be used alone or in combination of two or more.

The resin particularly preferably includes at least one resin selected from polyethylene terephthalate, polycarbonate, acrylic, silicone, and triacetyl cellulose from the viewpoint of excellent visible light transparency and availability.

In the present specification, when the transparent substrate includes a resin, the transparent substrate is also referred to as a resin substrate.

The shape of the resin substrate is preferably a film shape. When the resin substrate is in the form of a film, that is, when the resin substrate is a resin film, the thickness thereof is not particularly limited, but is preferably 20 μm to 300 μm, and more preferably 30 μm to 130 μm.

Examples of the case where the transparent substrate includes both a glass and a resin include a case where the transparent substrate is a composite substrate in which a glass substrate and a resin substrate are laminated. More specifically, the transparent substrate may be, for example, in a form in which the above resin substrate is provided on the above glass substrate.

(Diffusion Layer)

The diffusion layer in this aspect is provided on one main surface of the transparent substrate. The diffusion layer means a layer having a function of diffusing specularly reflected light and reducing glare and reflection, and examples thereof include an antiglare layer imparted with a function of diffusing specularly reflected light (antiglare property) in the hard coat layer.

Since the antiglare layer has an uneven shape on one surface thereof, the haze value is increased by external scattering or internal scattering to impart antiglare properties. The anti-glare layer is formed of, for example, an anti-glare layer composition obtained by dispersing, in a solution in which a polymer resin as a binder is dissolved, a particulate substance having at least anti-glare properties in itself. The antiglare layer can be formed, for example, by applying the antiglare layer composition to one main surface of a transparent substrate.

Examples of the particulate substance having antiglare properties include inorganic fine particles such as silica, clay, talc, calcium carbonate, calcium sulfate, barium sulfate, aluminum silicate, titanium oxide, synthetic zeolite, alumina, and smectite, and organic fine particles containing a styrene resin, a urethane resin, a benzoguanamine resin, a silicone resin, an acrylic resin, a melamine resin, or the like.

As the polymer resin as the binder of the hard coat layer or the antiglare layer, for example, a polymer resin containing a polyester-based resin, an acrylic resin, an acrylic urethane-based resin, a polyester acrylate-based resin, a polyurethane acrylate-based resin, an epoxy acrylate-based resin, a urethane-based resin, or the like can be used.

In the present aspect, the diffusion layer may be directly formed on the transparent substrate, or a configuration in which the diffusion layer is provided on the composite substrate of the glass substrate and the resin substrate may be obtained by preparing a laminate composed of the resin substrate and the antiglare layer in advance and bonding the laminate to the glass substrate or the like. In such a laminate, a diffusion layer is preferably formed on a film-like resin substrate. According to this method, the diffusion layer is more easily formed.

Specific examples of the laminate composed of the resin substrate and the antiglare layer include an antiglare PET film and an antiglare TAC film. Examples of the antiglare PET film include BHC-III and EHC-30 a (trade names) manufactured by Higashiyama Film Co., Ltd., and those manufactured by Reiko Co., Ltd. As the antiglare TAC film, an antiglare TAC film (trade name: VZ50, manufactured by TOPPAN TOMOEGAWA Optical Films Co., Ltd.) is used.

Alternatively, a diffusion layer may be formed on the surface layer of the transparent substrate itself by subjecting the transparent substrate to surface treatment.

For example, in the case of using a glass substrate, it is possible to use a method of performing a surface treatment on a glass main surface to form desired unevenness.

Specifically, a method of performing a chemical treatment on the main surface of the glass substrate, for example, a method of performing a frost treatment is exemplified. In the frost treatment, for example, a glass substrate to be treated is immersed in a mixed solution of hydrogen fluoride and ammonium fluoride, and the immersion surface can be chemically surface-treated.

In addition to the method by the chemical treatment such as the frost treatment, for example, a method by a physical treatment such as a so-called sandblast treatment in which a crystalline silicon dioxide powder, a silicon carbide powder, or the like is blown onto the surface of the glass substrate with pressurized air, or polishing with a brush to which a crystalline silicon dioxide powder, a silicon carbide powder, or the like is attached and which is wetted with water can be used.

The anti-reflection film-attached transparent substrate including such a diffusion layer has an uneven shape on the surface due to the uneven shape of the diffusion layer. The Sa (arithmetic average surface roughness) of the anti-reflection film-attached transparent substrate is preferably 0.05 $\mu$m to 0.6 $\mu$m, and more preferably 0.05 $\mu$m to 0.55 $\mu$m. When Sa is in this range, reflection of a reflected image is easily suppressed, which is preferable. Sa is defined in ISO25178 and can be measured using, for example, a laser microscope VK-X3000 manufactured by Keyence Corporation.

In the anti-reflection film-attached transparent substrate, a developed area ratio Sdr (hereinafter, also simply referred to as "Sdr") calculated from a surface area obtained by measurement using a laser microscope VK-X3000 manufactured by Keyence Corporation or the like is preferably 0.001 to 0.4, and more preferably 0.0025 to 0.2. When Sdr is in this range, reflection of a reflected image is easily suppressed, which is preferable.

Sdr is defined in ISO25178 and is represented by the following formula.

$$\text{Developed area ratio Sdr} = \{(A\text{-}B)/B\}$$

A: surface area (developed area) reflecting actual unevenness in measurement region
B: Area of flat surface without unevenness in measurement region

The Sdq (root mean square slope) of the anti-reflection film-attached transparent substrate is preferably 0.03 to 0.50, and more preferably 0.07 to 0.49. When Sdq is in this range, reflection of a reflected image is easily suppressed, which is preferable. The Sdq is defined in ISO25178 and can be measured with, for example, a laser microscope VK-X3000 manufactured by Keyence Corporation.

The Spc (average principal curvature of surface peaks) of the anti-reflection film-attached transparent substrate is preferably 150 to 6000 (1/mm). When Spc is in this range, reflection of a reflected image is easily suppressed, which is preferable. Spc is defined in ISO25178 and can be measured using, for example, a laser microscope VK-X3000 manufactured by Keyence Corporation.

The Sa, Sdr, Sdq, and Spc are values measured for the main surface of the anti-reflection film-attached transparent substrate on the side where the diffusion layer and the anti-reflection film are provided.

(Barrier Layer)

When the transparent substrate includes a resin substrate, for example, when the diffusion layer is formed by a method of bonding a laminate composed of a resin substrate and an antiglare layer to a glass substrate or the like, a barrier layer is preferably provided between the diffusion layer and the anti-reflection film. It is preferable to provide the barrier layer between the resin transparent substrate and the anti-reflection film because it is possible to suppress the influence of moisture or oxygen which is likely to enter the anti-reflection film from the resin substrate, and there is an advantage that the optical characteristics are hardly changed. Examples of the barrier layer include a metal nitride film and a metal oxide film, and specific examples thereof include a $SiN_x$ film and a $SiO_x$ film, and a $SiN_x$ film is more preferable from the viewpoint of more effectively suppressing a change in optical characteristics.

The thickness of the barrier layer is preferably 2 nm or more, more preferably 4 nm or more, and particularly preferably 8 nm or more, from the viewpoint of suppressing intrusion of moisture or the like into the anti-reflection film. On the other hand, the thickness is preferably 50 nm or less from the viewpoint of suppressing an increase in reflectance of the anti-reflection film-attached transparent substrate. The barrier layer can be formed using a known film forming method such as a sputtering method, a vacuum deposition method, or a coating method.

(Anti-reflection Film)

The anti-reflection film in the present aspect has a function of suppressing reflection of light, and has, for example, a laminated structure in which at least two dielectric layers having different refractive indexes are laminated.

The anti-reflection film (multilayer film) 30 shown in FIG. 1 has a laminated structure in which two layers of a first dielectric layer 32 and a second dielectric layer 34 having different refractive indices are laminated. By stacking the first dielectric layer 32 and the second dielectric layer 34 having different refractive indices, reflection of light is suppressed. For example, in FIG. 1, the first dielectric layer 32 is a high refractive index layer, and the second dielectric layer 34 is a low refractive index layer.

It is preferable that the anti-reflection film has a laminated structure in which at least two dielectric layers having refractive indexes different from each other are laminated, at least one layer of the dielectric layers is mainly composed of an oxide of Si, at least another layer among the layers of the laminated structure is mainly composed of a mixed oxide of an oxide containing at least one selected from the group A consisting of Mo and W and an oxide containing at least one selected from the group B consisting of Si, Nb, Ti, Zr, Ta, Al, Sn, and In, and a content of the element of the group B contained in the mixed oxide with respect to a total of the element of the group A contained in the mixed oxide and the element of the group B contained in the mixed oxide is 65 mass% or less. However, when it is desired to keep the luminance of the display high, or the like, in a case where an anti-reflection film having no light absorption ability or having relatively high transmittance and having a luminous transmittance of 90% or more as the anti-reflection film-attached transparent substrate is suitably used, an oxide containing at least one selected from Nb, Ti, Zr, Ta, Al, Sn, Mo, W, and In may be used as the layer not constituted by the oxide of Si. The layer mainly composed of an oxide of Si may contain an oxide containing at least one selected from Nb, Ti, Zr, Ta, Al, Sn, W, Mo, and In as long as the reflectance is not affected. An anti-reflection film having high hardness and little change in optical characteristics can be obtained by appropriately selecting a material to be an oxide.

In the anti-reflection film (multilayer film) 30 shown in FIG. 1, when an anti-reflection film is obtained such that the anti-reflection film-attached transparent substrate has a luminous transmittance of 96% or less, the first dielectric layer 32 (high refractive index layer) is preferably mainly composed of a mixed oxide of an oxide containing at least one selected from the group A consisting of Mo and W and an oxide containing at least one selected from the group B consisting of Si, Nb, Ti, Zr, Ta, Al, Sn and In. In the mixed oxide, the content of the element of the group B contained in the mixed oxide with respect to the total of the element of the group A contained in the mixed oxide and the element of the group B contained in the mixed oxide (hereinafter, referred to as a group B content) is preferably 65 mass% or less. Here, "mainly" means a component having the largest content (mass basis) in the first dielectric layer 32, and for example, means that the first dielectric layer 32 is configured to include 70 mass% or more of the corresponding component.

When the B group content in the first dielectric layer (A-B-O) 32 composed of a mixed oxide of an oxide containing at least one selected from the group A consisting of Mo and W and an oxide containing at least one selected from the group B consisting of Si, Nb, Ti, Zr, Ta, Al, Sn, and In is 65 mass% or less, the transmitted light can be suppressed from being yellowish.

At least one oxide selected from the group A is preferably Mo or Mo and W, and at least one oxide selected from the group B is preferably Nb. That is, the first dielectric layer is preferably a mixed oxide of Mo and Nb or a mixed oxide of Mo, W, and Nb, and more preferably a mixed oxide of Mo, W, and Nb.

As described later, the second dielectric layer may be, for example, an oxygen-deficient silicon oxide layer. Here, although a conventional oxygen-deficient silicon oxide layer is yellow in visible light, it is preferable that the first dielectric layer is a mixed oxide of Mo and Nb or a mixed oxide of Mo, W, and Nb because the silicon oxide layer can be prevented from being yellow. The silicon oxide layer may contain an oxide of at least one selected from Nb, Ti, Zr, Ta, Al, Sn, W, Mo, and In for the purpose of improving reliability, and each oxide may be oxygen-deficient. Further, when the second dielectric layer is formed on the diffusion layer having a relatively high haze as described above, that is, having a relatively large surface unevenness, high oxidation stability is required during film formation. When the first dielectric layer is a mixed oxide of Mo, W, and Nb, oxidation stability during film formation is likely to be excellent, which is more preferable.

The refractive index of the first dielectric layer 32 at a wavelength of 550 nm is preferably 1.8 to 2.5 from the viewpoint of transmittance to the transparent substrate.

The extinction coefficient of the first dielectric layer 32 is preferably 0.005 to 3, and more preferably 0.04 to 0.38. When the extinction coefficient is 0.005 or more, a desired absorbance can be achieved with an appropriate number of layers. When the extinction coefficient is 3 or less, it is relatively easy to achieve both the reflection color and the transmittance.

The second dielectric layer 34 (low refractive index layer) is preferably mainly composed of an oxide of Si ($SiO_x$). Here, "mainly" means a component having the largest content (mass basis) in the second dielectric layer 34, and for example, means that the second dielectric layer 34 is configured to include 70 mass% or more of the corresponding component. It is preferable that the second dielectric layer 34 (low refractive index layer) is mainly made of an oxide of Si ($SiO_x$) because the second dielectric layer 34 has a low refractive index and a high reflectance reduction effect. $SiO_x$ may be completely oxidized silicon oxide ($SiO_2$), but is preferably oxygen-deficient silicon oxide from the viewpoint of enhancing optical reliability and scratch resistance. The silicon oxide layer may contain an oxide of at least one selected from Nb, Ti, Zr, Ta, Al, Sn, W, Mo, and In for the purpose of improving reliability, and each oxide may be oxygen-deficient.

The anti-reflection film (multilayer film) 30 shown in FIG. 1 has a laminated structure of a total of two layers in which the first dielectric layer 32 and the second dielectric layer 34 are laminated, but the anti-reflection film (multilayer film) in the present aspect is not limited thereto, and may have a laminated structure in which three or more dielectric layers having different refractive indexes are laminated. In this case, the refractive indices of all the dielectric layers need not be different. For example, in the case of a three-layer laminated structure, a three-layer laminated structure of a low refractive index layer, a high refractive index layer, and a low refractive index layer, or a three-layer laminated structure of a high refractive index layer, a low refractive index layer, and a high refractive index layer can be used. In the former case, two low refractive index layers may have the same refractive index, and in the latter case, two high refractive index layers may have the same refractive index. In the case of a four-layer laminated structure, a four-layer laminated structure of a low refractive index layer, a high refractive index layer, a low refractive index layer, and a high refractive index layer, or a four-layer laminated structure of a high refractive index layer, a low refractive index layer, a high refractive index layer, and a low refractive index layer can be used. In this case, at least one of the two low refractive index layers and the two high refractive index layers may have the same refractive index. The same applies to a case where the number of stacked layers is increased, such as a five-layer laminated structure, a six-layer laminated structure, a seven-layer laminated structure, and an eight-layer laminated structure.

In the case of a laminated structure in which three or more layers having different refractive indices are laminated, dielectric layers other than the first dielectric layer (A-B-O) 32 and the second dielectric layer ($SiO_x$) 34 may be included. In this case, each layer is selected so as to have a three-layer laminated structure of a low refractive index layer, a high refractive index layer, and a low refractive index layer, a three-layer laminated structure of a high refractive index layer, a low refractive index layer, and a high refractive index layer, a four-layer laminated structure of a low refractive index layer, a high refractive index layer, a low refractive index layer, and a high refractive index layer, or a four-layer laminated structure of a high refractive index layer, a low refractive index layer, a high refractive index layer, and a low refractive index layer, including the first dielectric layer (A-B-O) 32 and the second dielectric layer ($SiO_x$) 34. The same applies to a case where the number of stacked layers is increased, such as a five-layer laminated structure, a six-layer laminated structure, a seven-layer laminated structure, and an eight-layer laminated structure.

However, the outermost layer is preferably the second dielectric layer ($SiO_x$) 34. In order to obtain low reflectivity, if the outermost layer is the second dielectric layer ($SiO_x$), it can be produced relatively easily. The second dielectric layer may contain an oxide of at least one selected from Nb, Ti, Zr, Ta, Al, Sn, W, Mo, and In for the purpose of improving reliability, although the reflectance may increase to some extent. In order to suppress an increase in reflectance, the content of metals other than Si is preferably 30 at% or less, more preferably 20 at% or less, and still more preferably 15 at% or less, except for oxygen. When an antifouling film described later is formed on the anti-reflection film 30, the antifouling film is preferably formed on the second dielectric layer ($SiO_x$) from the viewpoint of bonding properties related to durability of the antifouling film.

The first dielectric layer (A-B-O) 32 is preferably amorphous. If it is amorphous, it can be formed at a relatively low temperature, and when the transparent substrate includes a resin, the resin is not damaged by heat and can be suitably applied.

The anti-reflection film 30 in the present aspect can be formed on the main surface of the transparent substrate using a known film forming method such as a sputtering method, a vacuum deposition method, or a coating method. That is, the dielectric layer constituting the anti-reflection film 30 is formed on the main surface of the diffusion layer 31 by a known film forming method such as a sputtering method, a vacuum deposition method, or a coating method according to the stacking order.

Examples of the sputtering method include magnetron sputtering, pulse sputtering, AC sputtering, and digital sputtering.

For example, the magnetron sputtering method is a method in which a magnet is installed on the back surface of a dielectric material serving as a base material to generate a magnetic field, and gas ion atoms collide with the surface of the dielectric material and are sputtered to form a sputtering film having a thickness of several nm, and a continuous film of a dielectric which is an oxide or a nitride of the dielectric material can be formed.

For example, the digital sputtering method is different from a normal magnetron sputtering method, and is a method of forming a thin film of a metal oxide by repeating, in the same chamber, a process of first forming an extremely thin film of a metal by sputtering and then performing oxidation by irradiation with oxygen plasma, oxygen ions, or oxygen radicals. In this case, since the film forming molecules are a metal when deposited on the substrate, it is presumed that the film forming molecules have ductility as compared with the case of depositing the film using a metal oxide. Therefore, it is considered that the rearrangement of the film forming molecules easily occurs even with the same energy, and as a result, a dense and smooth film is formed.

Although an example of a preferable configuration of the anti-reflection film has been described above, the configuration of the anti-reflection film is not limited thereto. For example, when it is desired to maintain a high luminance of a display, an anti-reflection film which does not have a light absorption ability or has a relatively high transmittance and has a luminous transmittance of 90% or more as an anti-reflection film-attached transparent substrate may be suitably used. Even in such an anti-reflection film-attached transparent substrate including a highly transmissive anti-reflection film, when a* and b* of diffusely reflected light at each angle are within the above-described ranges, an effect of suppressing color deviation after tiling can be obtained. Examples of the configuration of the highly transmissive anti-reflection film include a configuration in which the low refractive index layer is formed in the same manner as the second dielectric layer 34 described above, and the high refractive index layer is a layer having no light absorption ability or a highly transmissive layer. Examples of the high refractive index layer in this case include a layer mainly composed of an oxide of Ti ($TiO_x$), a layer mainly composed of an oxide of Nb ($NbO_x$), and a layer mainly composed of an oxide of Ta ($TaO_x$), and a layer mainly composed of an oxide of Ti ($TiO_x$) is preferable from the viewpoint of low reflection. Also in this case, each layer forming the anti-reflection film can be formed using a known film forming method such as a sputtering method, a vacuum deposition method, or a coating method.

The luminous transmittance (Y) of the anti-reflection film-attached transparent substrate in the case of including a highly transmissive anti-reflection film may be, for example, 90% to 96%, and is preferably 93% to 96%.

(Antifouling Film)

From the viewpoint of protecting the outermost surface of the anti-reflection film, the anti-reflection film-attached transparent substrate of the present aspect may further have an antifouling film (also referred to as an "anti-finger print (AFP) film") on the anti-reflection film. The antifouling film can be made of, for example, a fluorine-containing organosilicon compound. The fluorine-containing organosilicon compound is not particularly limited as long as it can impart antifouling properties, water repellency, and oil repellency, and examples thereof include fluorine-containing organosilicon compounds having one or more groups selected from the group consisting of polyfluoropolyether groups, polyfluoroalkylene groups, and polyfluoroalkyl groups. The polyfluoropolyether group is a divalent group having a structure in which a polyfluoroalkylene group and an ethereal oxygen atom are alternately bonded.

As a fluorine-containing organosilicon compound having one or more groups selected from the group consisting of a polyfluoropolyether group, a polyfluoroalkylene group, and a polyfluoroalkyl group which are commercially available, KP-801 (trade name, manufactured by Shin-Etsu Chemical Co., Ltd.), KY178 (trade name, manufactured by Shin-Etsu Chemical Co., Ltd.), KY-130 (trade name, manufactured by Shin-Etsu Chemical Co., Ltd.), KY-185 (trade name, manufactured by Shin-Etsu Chemical Co., Ltd.), OPTOOL (registered trademark) DSX, OPTOOL AES (all trade names, manufactured by Daikin Industries, Ltd.), and the like can be preferably used.

When the anti-reflection film-attached transparent substrate of the present aspect has an antifouling film, the antifouling film is provided on the anti-reflection film. When the anti-reflection film is provided on both sides of the two main surfaces of the transparent substrate, the antifouling film may be formed on both the anti-reflection films, or the antifouling film may be laminated on only one of the main surfaces. This is because the antifouling film may be provided at a place where a human hand or the like may come into contact, and the antifouling film can be selected according to the use or the like. The film thickness of the antifouling film is, for example, preferably 2 nm to 9 nm, and more preferably 3 nm to 7 nm.

(Method for Producing Anti-reflection Film-attached Transparent Substrate)

The method for producing the anti-reflection film-attached transparent substrate of the present aspect is not particularly limited, and for example, the anti-reflection film-attached transparent substrate can be produced by a method including forming a diffusion layer and an antireflective film in this order on a transparent substrate. If necessary, the method may further include forming a layer such as a barrier layer or an antifouling film.

The method of forming each layer is as described above, but in order for a* and b* of the diffusely reflected light at each angle to satisfy the requirements described above, it is preferable to appropriately adjust values such as the film configuration of the anti-reflection film and the luminous transmittance (Y) of the anti-reflection film-attached transparent substrate. In the case of an anti-reflection film-attached transparent substrate having a high transmittance, it is difficult to optimize the transmittance, and thus it is preferable to more strictly adjust the thickness of each layer of the anti-reflection film.

As a specific adjustment method, for example, in the case of obtaining the anti-reflection film-attached transparent substrate according to the embodiment of the present invention, it is important to design a film so as to balance the diffusion reflectance of yellow light of 500 nm to 600 nm with respect to blue light of 450 nm to 500 nm and red light of 600 nm to 650 nm. In particular, by making the reflection spectrum significant for yellow light in a range where the diffuse reflection is high with respect to 45° light incidence at -15°, 15°, and 25°, the diffusion reflection color tends to be able to be maintained in yellow to colorless to light blue. In this case, the specular reflection color of 5° incidence tends to be light blue, and it is preferable to make the blue light reflectance at 450 nm to 500 nm as a 5° specular reflection spectrum higher than that of yellow light or red light in order to realize the present invention.

Furthermore, for example, when the following is satisfied, the anti-reflection film-attached transparent substrate according to the embodiment of the present invention tends to be easily obtained.

For example, the total film thickness of the anti-reflection film is preferably 200 nm to 250 nm, and more preferably 210 nm to 245 nm. Accordingly, it is possible to suppress an increase in the angle dependence of the diffusion reflection color, that is, an increase in the change in the color tone of the diffusely reflected light due to the angle, and the expressions (1) and (2) tend to be easily satisfied.

The number of layers of the anti-reflection film is preferably 4 to 8, and more preferably 4 to 6. As a result, it is possible to suppress an increase in the angle dependence of the diffusion reflection color while securing mass productivity, and it tends to satisfy expressions (1) and (2).

As for the thickness of each layer, the thickness of the first high refractive index layer is most important, and is preferably 2 nm to 15 nm, and more preferably 3 nm to 12 nm. The thickness of the low refractive index layer of the outermost surface is also important, and by adjusting the film thickness together with the high refractive index layer of the first layer, it is possible to suppress an increase in the angle dependence of the diffusion reflection color, that is, the change in the color tone of the diffusely reflected light due to the angle, and there is a tendency that expressions (1) and (2) are easily satisfied. Specifically, when the high refractive index layer of the first layer is thin, the reflection color becomes green and a* becomes negative, and thus it is preferable to thicken the high refractive index layer of the first layer to such an extent that the green color becomes thin (about 4 nm to 9 nm although depending on the film configuration). When the low refractive index layer on the outermost surface (the sixth layer in the examples) is thin, the reflection color becomes reddish and a* becomes positive, or becomes yellowish and b* becomes positive, so that the low refractive index layer on the outermost surface is preferably in an appropriate range (about 80 nm to 95 nm depending on the film configuration) so that the reflection color becomes light blue. As a method of adjusting the film thickness, first, the reflection spectrum is adjusted so that the reflectance becomes low in a range as wide as possible by making the high refractive index layer of the first layer slightly thick or the like, and then the blue light reflectance in the vicinity of 450 nm is increased by making the low refractive index layer of the outermost surface slightly thick, whereby the reflection color form of the present invention is easily obtained.

In order to satisfy the requirement that the luminous reflectance (SCI Y) on the outermost surface of the anti-reflection film-attached transparent substrate of the present aspect is 1.2% or less, it is preferable to appropriately adjust values such as the film configuration of the anti-reflection film and the luminous transmittance (Y) of the anti-reflection film-attached transparent substrate. In the case of an anti-reflection film-attached transparent substrate having a high transmittance, it is difficult to optimize the transmittance, and thus it is preferable to more strictly adjust the thickness of each layer of the anti-reflection film.

As a specific adjustment method, when a mixed oxide of an oxide containing at least one selected from the group A consisting of Mo and W and an oxide containing at least one selected from the group B consisting of Si, Nb, Ti, Zr, Ta, Al, Sn and In is mainly used as the first dielectric, and the amount of oxidation of the film is adjusted to absorb visible light, the diffuse reflection component of the transparent substrate can be absorbed by the anti-reflection film, so that the luminous reflectance (SCI Y) is easily reduced.

(Applications)

The anti-reflection film-attached transparent substrate of the present aspect is suitably used as a surface material of an image display device, particularly, a surface material of a display obtained by tiling a plurality of LED panels or the like, such as a large μ-LED display. Alternatively, the anti-reflection film-attached transparent substrate of the present aspect is also suitably used in a case where the haze required for the anti-reflection film-attached transparent substrate is relatively high and the change in color tone depending on the angle is more likely to be remarkable. In addition, the anti-reflection film-attached transparent substrate of the present aspect is also suitably used as a surface material of various image display devices such as a liquid crystal display, an organic EL display, and an electronic paper display.

(Image Display Device)

An image display device according to an embodiment of the present invention includes the anti-reflection film-attached transparent substrate according to the embodiment of the present invention. Examples of the image display device include an embodiment in which the above-described anti-reflection film-attached transparent substrate is provided on a small LED panel used by tiling, and an embodiment of a large display, preferably a large μ-LED display, obtained by tiling the anti-reflection film-attached transparent substrate. In addition, an embodiment in which the anti-reflection film-attached transparent substrate is provided on various displays such as a liquid crystal display, an organic EL display, and an electronic paper display is exemplified.

As described above, the following matters are disclosed in the present specification.

1. An anti-reflection film-attached transparent substrate including: a transparent substrate having two main surfaces; and a diffusion layer and an anti-reflection film in this order from a transparent substrate side on one main surface of the transparent substrate,

in which when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1) and (2).

$$(1)\ {-2}{\leq}a^{*}{\leq}4.5$$

$$(2)\ {-5}{\leq}b^{*}{\leq}10$$

2. An anti-reflection film-attached transparent substrate including: a transparent substrate having two main surfaces; and a diffusion layer and an anti-reflection film in this order from a transparent substrate side on one main surface of the transparent substrate,

in which when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1') and (2') .

$$(1')\ {-2}{\leq}a^{*}{\leq}4.5$$

$$(2')\ {-3}{\leq}b^{*}{\leq}13$$

3. The anti-reflection film-attached transparent substrate according to the above 1, in which a luminous reflectance (SCI Y) on an outermost surface is 1.2% or less.

4. The anti-reflection film-attached transparent substrate according to any one of the above 1 to 3, in which a* and b* of SCI on an outermost surface satisfy the following expressions (3) and (4):

$$(3)\ -1\leq a^*\leq 2$$

$$(4)\ -5\leq b^*\leq 0$$

5. The anti-reflection film-attached transparent substrate according to any one of the above 1 to 4, having a haze value of 25% or more.

6. The anti-reflection film-attached transparent substrate according to any one of the above 1 to 5, in which L* of the diffusely reflected light in 15° under a D65 light source is 5 to 35, and L* of the diffusely reflected light in 25° is 0 to 20.

7. The anti-reflection film-attached transparent substrate according to any one of the above 1 to 6, in which a luminous transmittance (Y) is 20% to 96%.

8. The anti-reflection film-attached transparent substrate according to any one of the above 1 to 7, in which the anti-reflection film has a sheet resistance of $10^4\ \Omega/\square$ or more.

9. The anti-reflection film-attached transparent substrate according to any one of the above 1 to 8, in which b* of a transmission color under a D65 light source is 5 or less.

10. The anti-reflection film-attached transparent substrate according to any one of the above 1 to 9, in which the anti-reflection film has a laminated structure in which at least two dielectric layers having refractive indices different from each other are laminated, at least one layer of the dielectric layers is mainly composed of an oxide of Si, at least another layer among layers of the laminated structure is mainly composed of a mixed oxide of an oxide containing at least one selected from the group A consisting of Mo and W and an oxide containing at least one selected from the group B consisting of Si, Nb, Ti, Zr, Ta, Al, Sn and In, and a content of elements of the group B contained in the mixed oxide is 65 mass% or less with respect to a total of elements of the group A contained in the mixed oxide and the elements of the group B contained in the mixed oxide.

11. The anti-reflection film-attached transparent substrate according to any one of the above 1 to 10, further including an antifouling film on the anti-reflection film.

12. The anti-reflection film-attached transparent substrate according to any one of the above 1 to 11, in which the transparent substrate includes a glass.

13. The anti-reflection film-attached transparent substrate according to any one of the above 1 to 11, in which the transparent substrate includes at least one resin selected from polyethylene terephthalate, polycarbonate, acrylic, silicone, and a triacetylcellulose resin film.

14. The anti-reflection film-attached transparent substrate according to any one of the above 1 to 13, in which the transparent substrate is a laminate of a glass and at least one resin selected from polyethylene terephthalate, polycarbonate, acrylic, silicone, and a triacetylcellulose resin film.

15. The anti-reflection film-attached transparent substrate according to the above 14, in which the glass is chemically strengthened.

16. An image display device including the anti-reflection film-attached transparent substrate according to any one of the above 1 to 15.

EXAMPLES

Hereinafter, the present invention will be specifically described with reference to Examples, but the present invention is not limited thereto. Examples 1 to 4, 10, and 11 are inventive examples, and Examples 5 to 9 are comparative examples.

(Evaluation)

The anti-reflection film-attached transparent substrate of each example was evaluated as follows.
(a* b* L* of diffusely reflected light at each angle)

A black tape (manufactured by TOMOEGAWA CORPORATION., KUKKIRI MIERU; the diffusion reflectance corresponds to approximately 0.01% in SCE Y with a D65 light source) was attached to the main surface (the other main surface) of the anti-reflection film-attached transparent substrate not having the diffusion layer and the anti-reflection film. Accordingly, the light source was incident on the main surface (one main surface) having the diffusion layer and the anti-reflection film at an incident angle of 45° while removing the reflection on the other main surface. For each diffusely reflected light having an angle of -15°, 15°, 25°, 45°, 75°, and 110° with respect to the specularly reflected light, the reflectance at a visible light wavelength was measured, and a*, b*, and L* under a D65 light source were calculated (diffusion reflection color). The measurement was performed using CM-M6 manufactured by Konica Minolta, Inc.

(Luminous Reflectance (SCI Y) and Reflection Color (SCI a*, b*))

For the luminous reflectance and the reflection color (SCI Y a*, b*) of the outermost surface of the anti-reflection film-attached transparent substrate, the luminous reflectance of the outermost surface of the anti-reflection film-attached transparent substrate was measured using a D65 light source and a spectrophotometer (manufactured by Konica Minolta, Inc., trade name: CM-26d) according to the method specified in JIS Z 8722 (2009). In the measurement, a black tape (manufactured by TOMOEGAWA CORPORATION., KUKKIRI MIERU) was attached to the main surface (the other main surface) of the anti-reflection film-attached transparent substrate not having the diffusion layer and the antireflective film.

(Haze)

The haze value (transmission haze) of the produced anti-reflection film-attached transparent substrate was measured according to JIS K 7136: 2000 using a haze meter (HZ-V3) manufactured by Suga Test Instruments Co., Ltd.

(Luminous Transmittance: Y)

In the produced anti-reflection film-attached transparent substrate, the luminous transmittance (Y) of the outermost surface of the anti-reflection film was measured by a method specified in JIS Z 8701 (1999). In the present specification, the luminous transmittance (Y) of the anti-reflection film was defined as the luminous transmittance (Y) of the anti-reflection film-attached transparent substrate. Specifically, the spectral transmittance is measured with a spectrophotometer (manufactured by Shimadzu Corporation, trade name: SolidSpec-3700), and the luminous transmittance (a stimulus value Y specified in JIS Z 8701 (1999)) was determined by calculation using a D65 light source.

(Transmission Color (b* Value) under D65 Light Source of Anti-reflection Film-attached Transparent Substrate)

From the transmission spectrum obtained by measuring the spectral transmittance, a color index (b* value) specified in JIS Z 8729 (2004) was obtained. A D65 light source was used as the light source.

(Sheet Resistance of Anti-reflection Film)

The sheet resistance value was measured according to JIS K 6911 (2006) using a measurement device (manufactured by Mitsubishi Chemical Analytech Co., Ltd., device name: Hiresta UP (MCP-HT450 type). The measurement was performed by applying a probe to the center of the anti-reflection film-attached transparent substrate and applying a current at 10 V for 10 seconds.

(Evaluation of Color Deviation)

For each example, 16 anti-reflection film-attached transparent substrates prepared under the same conditions were prepared and tested. For example, in the case of Example 1, 16 anti-reflection film-attached transparent substrates produced by slightly changing the film thickness of each layer from the conditions of Example 1 and the conditions of Example 1 were prepared, and a black tape (manufactured by TOMOEGAWA CORPORATION., KUKKIRI MIERU; the diffusion reflectance corresponds to approximately 0.01% in SCE Y with a D65 light source) was attached to the main surface (the other main surface) not having a diffusion layer and an anti-reflection film, and then 4 pieces × 4 pieces were arranged (tiled) without a gap. The color deviation of the anti-reflection film-attached transparent substrate after tiling was visually evaluated according to the following criteria. The other examples were tested in the same manner. The evaluation results are shown in Table 1.

A: When the white LED illumination was reflected on the main surface (one main surface) of the anti-reflection film-attached transparent substrate on the side having the diffusion layer and the anti-reflection film and viewed from various angles, the change in color of the white illumination reflected on the anti-reflection film-attached transparent substrate was limited, and the difference in color between the substrates was not noticeable. Further, in a front view, the reflection color of the anti-reflection film-attached transparent substrate had a light blue feeling, and a remarkably good quality as a surface material of a display was obtained.
B: When the white LED illumination was reflected on the main surface (one main surface) on the side having the diffusion layer and the anti-reflection film of the anti-reflection film-attached transparent substrate and viewed from various angles, the change in the color tone of the white illumination reflected on the anti-reflection film-attached transparent substrate was limited, and the difference in the color of each substrate was not noticeable, but the blackness of the anti-reflection film-attached transparent substrate was slightly varied for each tiled small piece due to mixing of slight green by the small piece in a front view, and the uniformity of the color tone after tiling was slightly inferior to the level of A.

C: When the white LED illumination was reflected on the main surface (one main surface) of the anti-reflection film-attached transparent substrate on the side having the diffusion layer and the anti-reflection film and viewed from various angles, the white illumination reflected on the anti-reflection film-attached transparent substrate appeared in various colors such as achromatic color, red color, blue color, and green color, and the color difference between the substrates was noticeable.

(Example 1)

A diffusion layer and an anti-reflection film were formed in this order on one main surface of a transparent substrate by the following method to produce an anti-reflection film-attached transparent substrate. As will be described later, the transparent substrate included a resin substrate on a glass substrate.

(Formation of Diffusion Layer)

A diffusion layer was provided on a transparent substrate by bonding, as a laminate (resin film + antiglare layer), an antiglare PET film (manufactured by Reiko Co., Ltd., Sa: 0.259 $\mu$m, Sdr: 0.0620, Sdq: 0.361, Spc: 1703 (1/mm), haze value: 60%) onto one main surface of a chemically strengthened glass substrate (Dragontrail: registered trademark, manufactured by AGC Inc.) having a length of 50 mm, a width of 50 mm, and a thickness of 1.1 mm with an acrylic adhesive (transparent adhesive). Here, Sa, Sdr, Sdq, and Spc are values measured in a state where the anti-reflection film is not formed on the diffusion layer, but Sa, Sdr, Sdq, and Spc in the anti-reflection film-attached transparent substrate after the formation of the anti-reflection film also have little change from the above values, and are considered to be within the preferable ranges described above.

(Formation of Barrier Layer)

Next, a SiN layer having a thickness shown in Table 1 was formed as a barrier layer on the diffusion layer. In Example 1, the thickness of the barrier layer is 9 nm.

For the barrier layer, pulse sputtering was performed by a digital sputtering method using a silicon target under conditions of a frequency of 100 kHz, a power density of 10.0 W/cm$^2$, and a reverse pulse width of 3 $\mu$sec while maintaining a pressure of 0.2 Pa with an argon gas to form a silicon film having a minute film thickness, and immediately thereafter, nitridation with a nitrogen gas was performed, which was repeated at a high speed to form a silicon nitride film, and a layer made of silicon nitride (SiN$_x$) having a predetermined film thickness was formed. Here, the nitrogen flow rate when nitriding with nitrogen gas was 800 sccm, and the input power of the nitriding source was 600 W.

(Formation of Anti-reflection Film)

Next, an NMWO layer (high refractive index layer) and an SiO layer (low refractive index layer) were alternately formed on the barrier layer to form an anti-reflection film having a film configuration shown in Table 1. The NMWO layer means a mixed oxide layer of Nb, Mo, and W. For example, the film configuration of the anti-reflection film of Example 1 in Table 1 means that an anti-reflection film having a film configuration of six layers was formed by forming a 5 nm NMWO layer on the barrier layer, then forming a 40 nm SiO layer, then forming a 45 nm NMWO layer, then forming a 15 nm SiO layer, then forming a 45 nm NMWO layer, and then forming a 85 nm SiO layer. The SiO layer and the NMWO layer were formed by the following methods.

(Formation of NMWO Layer)

In a digital sputtering method, using a target obtained by mixing and sintering niobium, molybdenum, and tungsten at a mass ratio of 24.3:29.7:46, pulse sputtering was performed under conditions of a frequency of 100 kHz, a power density of 10.0 W/cm$^2$, and a reverse pulse width of 3 $\mu$sec while maintaining a pressure of 0.2 Pa with argon gas to form a metal film having a minute film thickness, and immediately after that, oxidation with oxygen gas was performed, which was repeated at a high speed to form an oxide film, thereby forming a NMWO layer having a predetermined film thickness. When the composition of the NMWO layer formed by this method was measured by X-ray photoelectron spectroscopy (XPS) composition analysis in the depth direction using argon ion sputtering, Nb was 31.5 at%, Mo was 38.1 at%, and W was 30.5 at% except for oxygen, and the B group element content was 24.3 mass%.

(Formation of SiO$_x$ Layer)

Pulse sputtering was performed by a digital sputtering method using a silicon target under conditions of a frequency of 100 kHz, a power density of 10.0 W/cm$^2$, and a reverse pulse width of 3 $\mu$sec while maintaining a pressure of 0.2 Pa with an argon gas to form a silicon film having a minute film thickness, and immediately thereafter, oxidation with an oxygen gas was performed, which was repeated at a high speed to form a silicon oxide film, thereby forming a layer made of silicon oxide [silica (SiO$_x$)] having a predetermined film thickness. Here, the oxygen flow rate when oxidizing with oxygen gas was 500 sccm, and the input power of the oxidation source was 1000 W.

(Formation of Antifouling Film)

KY-185 (trade name, manufactured by Shin-Etsu Chemical Co., Ltd.) as a fluorine-containing organosilicon compound was put into a metal crucible (evaporation source) and heated and evaporated at 230°C to 350°C. The evaporated particles were evaporated and diffused into a chamber in a vacuum state in which the substrate was placed, and were attached to the surface of the substrate. Under the control of the crystal oscillator, an antifouling film having a thickness of 4 nm was formed while monitoring the vapor deposition rate.

(Sheet Resistance)

The sheet resistance of the anti-reflection film measured by the above-described method was 2 $\times$ 10$^9$ $\Omega/\square$.

(Examples 2 and 3)

An anti-reflection film-attached transparent substrate was obtained in the same manner as in Example 1 except that the film configuration of the anti-reflection film was changed as shown in Table 1. The sheet resistances of the anti-reflection films measured by the above-described method were 3 $\times$ 10$^9$ $\Omega/\square$ and 4 $\times$ 10$^9$ $\Omega/\square$, respectively.

(Example 4)

An anti-reflection film-attached transparent substrate was obtained in the same manner as in Example 1 except that an antiglare TAC film (VZ50 manufactured by TOPPAN TOMOEGAWA Optical Films Co., Ltd., Sa: 0.15 $\mu$m, Sdr: 0.0014, Sdq: 0.053, Spc: 163 (1/mm), haze value: 30%) was used as a laminate (resin film + antiglare layer), and the film configuration of the anti-reflection film was changed as shown in Table 1. The sheet resistance of the anti-reflection film measured by the above-described method was 2 $\times$ 10$^9$ $\Omega/\square$.

(Example 5)

An anti-reflection film-attached transparent substrate was obtained in the same manner as in Example 1 except that the thickness of the barrier layer and the film configuration of the anti-reflection film were changed as shown in Table 2 and an anti-reflection film having a film configuration of four layers was formed. The sheet resistance of the anti-reflection film measured by the method described above was 4 $\times$ 10$^9$ $\Omega/\square$.

(Example 6)

An anti-reflection film-attached transparent substrate was obtained in the same manner as in Example 5 except that the film configuration of the anti-reflection film was changed as shown in Table 2 and an anti-reflection film having a film configuration of six layers was formed. The sheet resistance of the anti-reflection film measured by the above-described method was 3 $\times$ 10$^9$ $\Omega/\square$.

(Example 7)

An anti-reflection film-attached transparent substrate was obtained in the same manner as in Example 5 except that the film configuration of the anti-reflection film was changed as shown in Table 2, and an anti-reflection film having a film configuration composed of six layers was formed using a Nb$_2$O$_5$ layer as the high refractive index layer. The sheet resistance of the anti-reflection film measured by the above-described method was 1 $\times$ 10$^{11}$ $\Omega/\square$.
The Nb$_2$O$_5$ layer was formed by the following method.

19

(Formation of $Nb_2O_5$ Layer)

Pulse sputtering was performed by a digital sputtering method using a niobium target under conditions of a frequency of 100 kHz, a power density of 10.0 W/cm$^2$, and a reversal pulse width of 3 $\mu$sec while maintaining a pressure of 0.2 Pa with an argon gas to form a metal film having a minute film thickness, and immediately after that, oxidation with an oxygen gas was performed, which was repeated at a high speed to form an oxide film, thereby forming a layer made of niobium oxide [niobia ($Nb_2O_5$)] having a predetermined film thickness. Here, the oxygen flow rate when oxidizing with oxygen gas was 1000 sccm, and the input power of the oxidation source was 1000 W.

(Example 8)

An anti-reflection film-attached transparent substrate was obtained in the same manner as in Example 5 except that the film configuration of the anti-reflection film was changed as shown in Table 2, and an anti-reflection film having a film configuration including four layers was formed using a $TiO_2$ layer as the high refractive index layer. The sheet resistance of the anti-reflection film measured by the above-described method was $5 \times 10^9$ $\Omega/\square$.
The $TiO_2$ layer was formed by the following method.

(Formation of $TiO_2$ Layer)

Pulse sputtering was performed by a digital sputtering method using a titanium target under conditions of a frequency of 100 kHz, a power density of 10.0 W/cm$^2$, and a reverse pulse width of 3 $\mu$sec while maintaining a pressure of 0.2 Pa with an argon gas to form a metal film having a minute film thickness, and immediately after that, oxidation with an oxygen gas was performed, which was repeated at a high speed to form an oxide film, thereby forming a layer made of titanium oxide [titania ($TiO_2$)] having a predetermined film thickness. Here, the oxygen flow rate when oxidizing with oxygen gas was 1000 sccm, and the input power of the oxidation source was 1000 W.

(Example 9)

An anti-reflection film-attached transparent substrate was obtained in the same manner as in Example 5 except that the film configuration of the anti-reflection film was changed as shown in Table 2. The sheet resistance of the anti-reflection film measured by the above-described method was $3 \times 10^9$ $\Omega/\square$.

(Example 10)

An anti-reflection film-attached transparent substrate was obtained in the same manner as in Example 1 except that the visible light absorptance of the film was reduced by increasing the amount of oxygen gas when forming the NMWO layer, and the film configuration of the anti-reflection film was changed as shown in Table 1. The sheet resistance of the anti-reflection film measured by the above-described method was $4 \times 10^9$ $\Omega/\square$.

(Example 11)

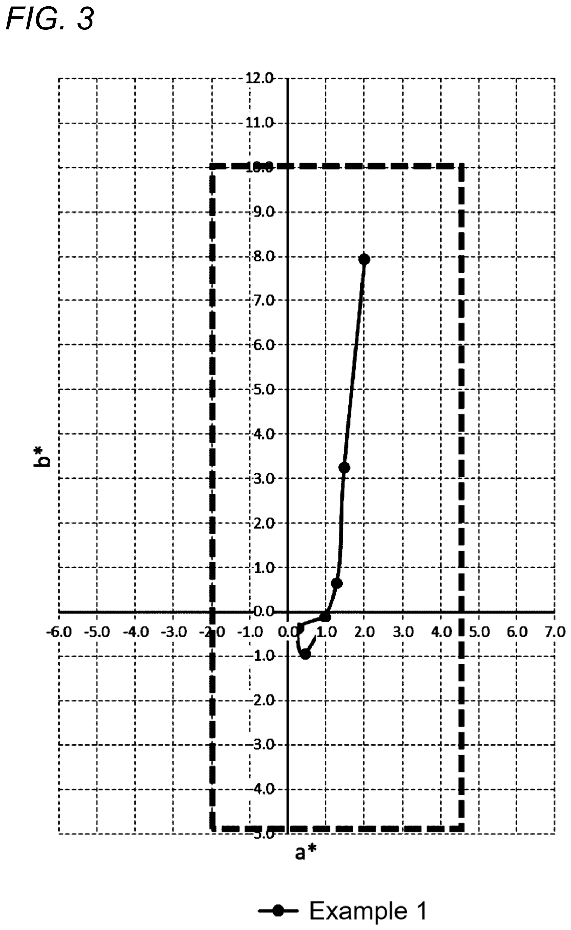

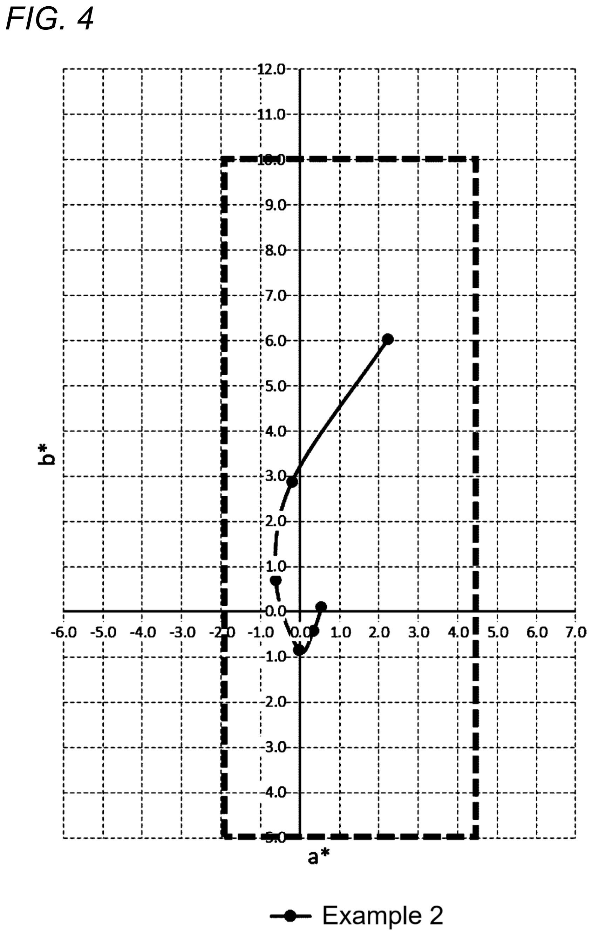

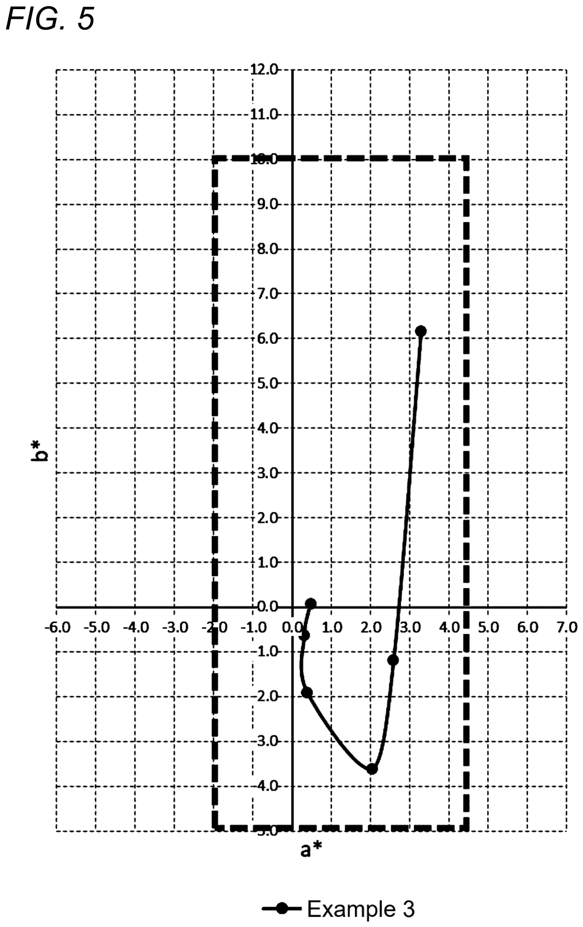

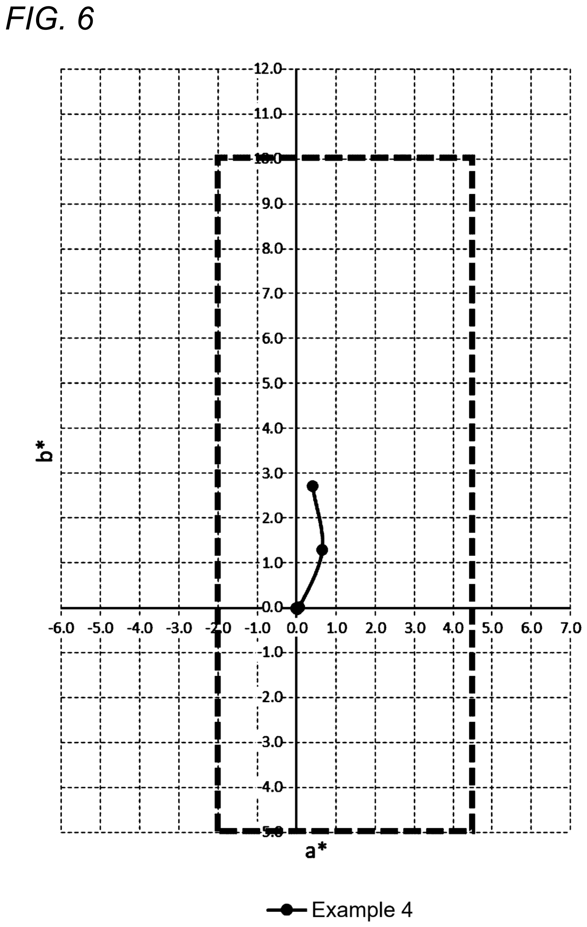

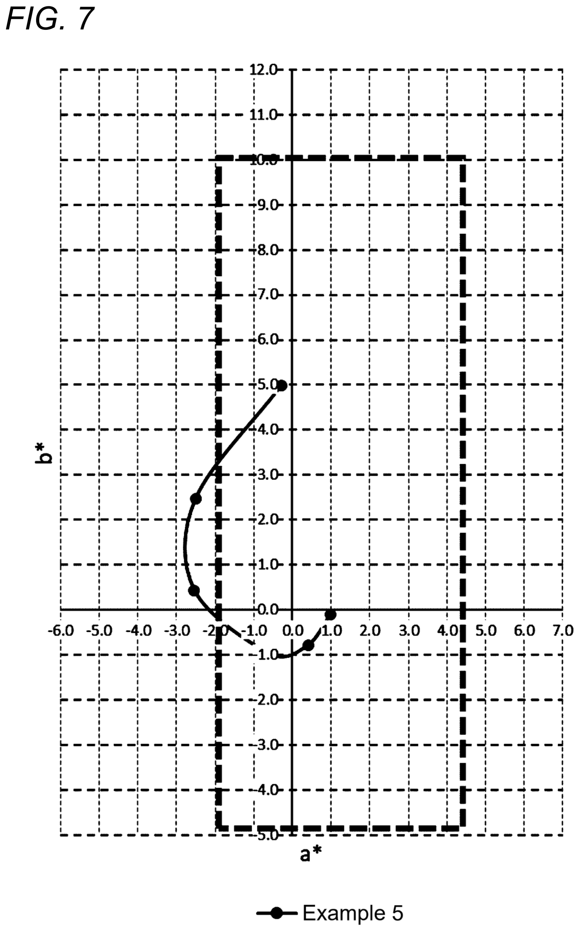

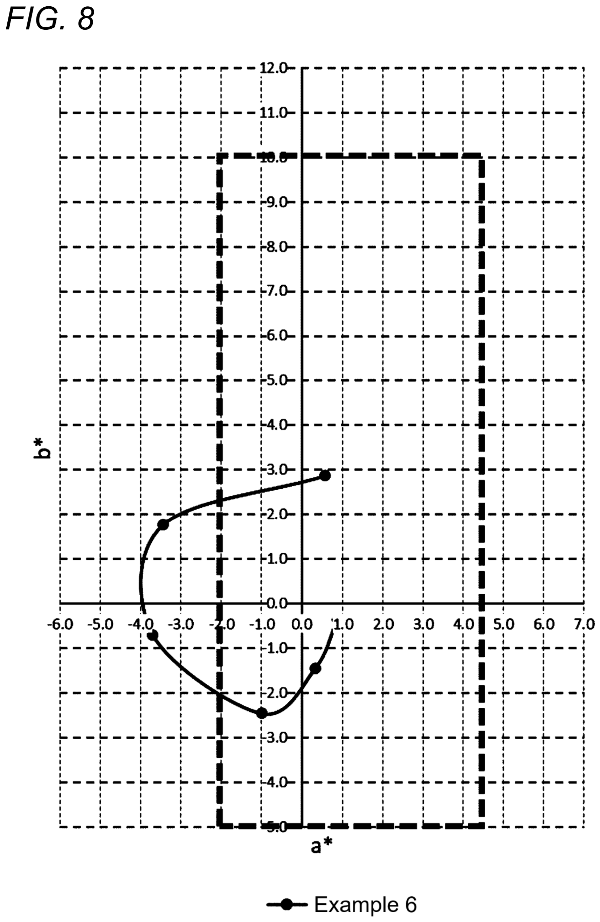

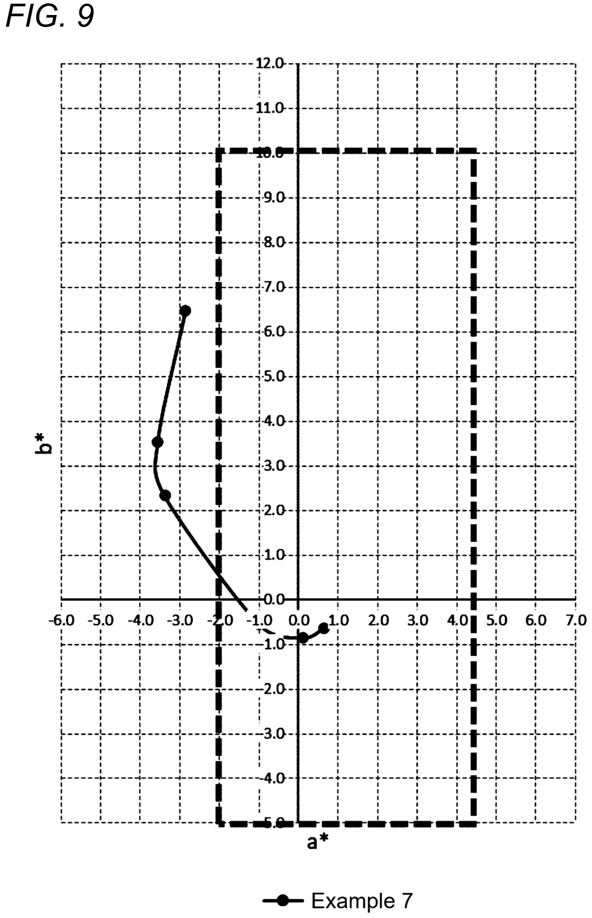

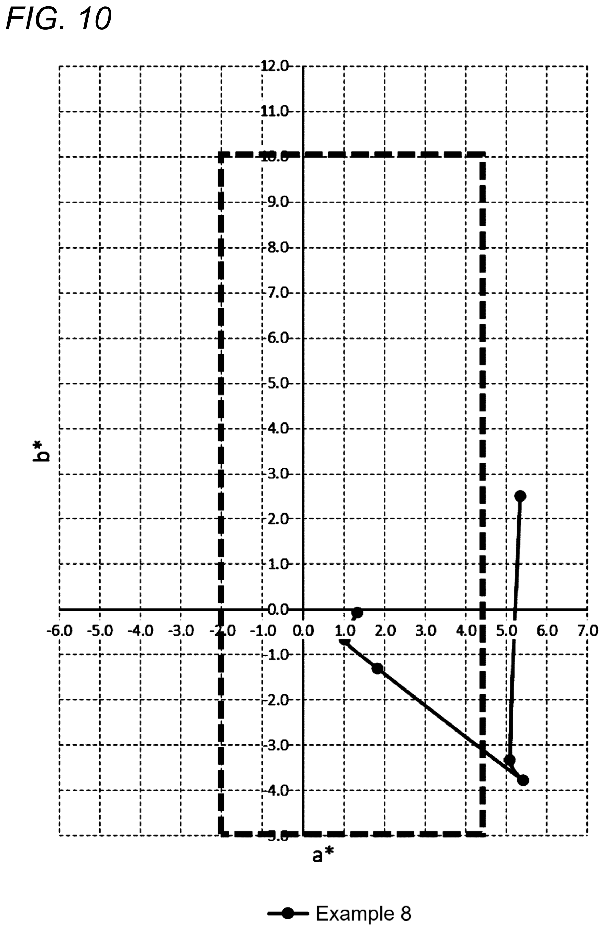

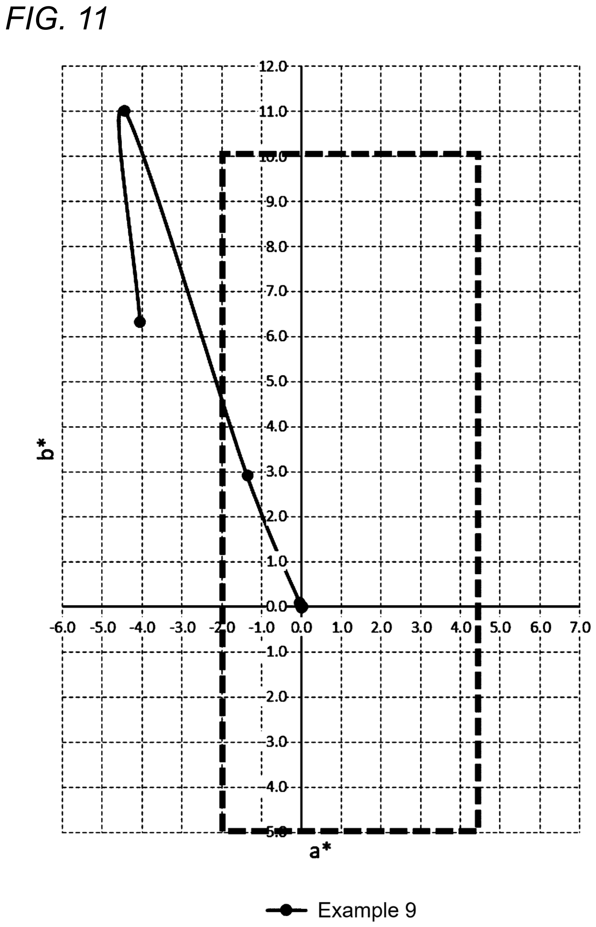

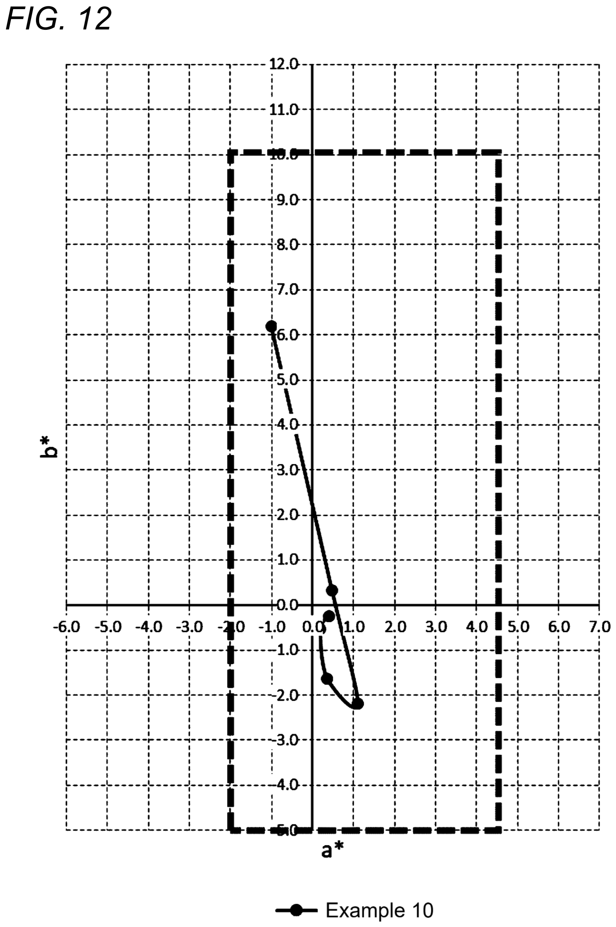

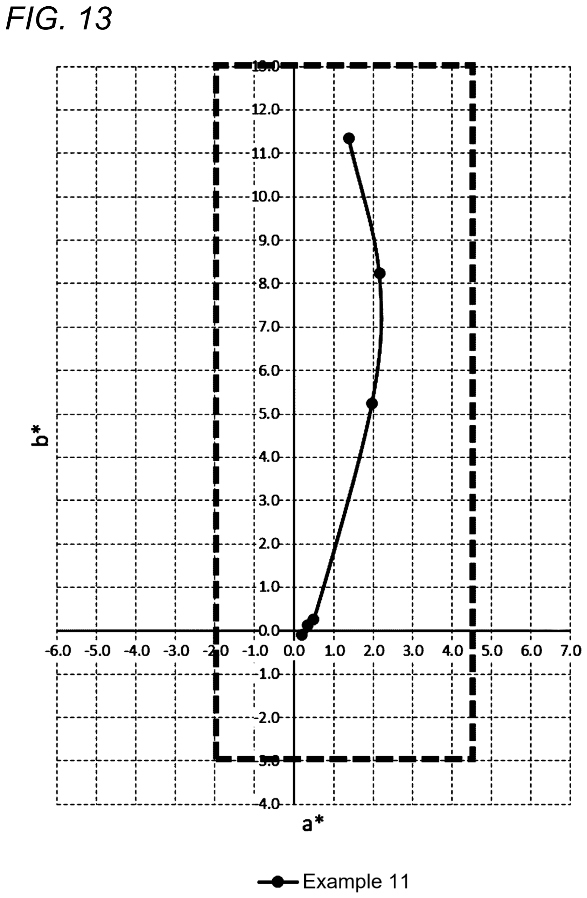

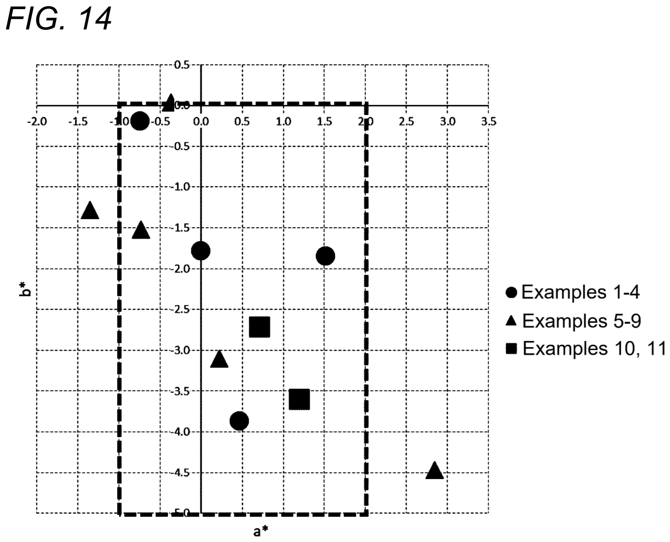

An anti-reflection film-attached transparent substrate was obtained in the same manner as in Example 1 except that the film configuration of the anti-reflection film was changed as shown in Table 1. The sheet resistance of the anti-reflection film measured by the above-described method was $3 \times 10^9$ $\Omega/\square$.
Table 1, Table 2, and Table 3 show the results of the evaluations described above for the anti-reflection film-attached transparent substrates obtained in the respective examples. a* and b* of the diffusely reflected light at each angle in Examples 1 to 11 are shown in FIGS. 3 to 13, respectively, and a* and b* of SCI in Examples 1 to 11 are shown in FIG. 14. In FIGS. 3 to 12, when the plot is located in the region indicated by the dotted line, it means that a* and b* satisfy the expressions (1) and (2). In FIG. 13, when the plot is located in the region indicated by the dotted line, it means that a* and b* satisfy the expressions (1') and (2').
In FIG. 14, when the plot is located in the region indicated by the dotted line, it means that a* and b* satisfy the expressions (3) and (4).

[Table 1]

| | | | Example 1 | Example 2 | Example 3 | Example 4 |
|---|---|---|---|---|---|---|
| Number of layers in anti-reflection film | | | 6 | 6 | 6 | 6 |
| Luminous transmittance Y (D65) (%) | | | 61.5 | 60.0 | 61.8 | 46.4 |
| b* of transmission color under D65 light source | | | 1.1 | 1.8 | 1.1 | 2.0 |
| Transmission haze (%) | | | 58 | 58 | 58 | 30 |
| High refractive index laver | | | NMWO | NMWO | NMWO | NMWO |
| Diffusion reflection color | | | blue and yellow | blue and yellow | blue and yellow | blue and yellow |
| Antifouling film | | KY-185 (nm) | 4 | 4 | 4 | 4 |
| Anti-reflectio n film | 6 | Low refractive index layer (nm) | 85 | 90 | 92 | 83 |
| | 5 | High refractive index layer (nm) | 45 | 45 | 45 | 42 |
| | 4 | Low refractive index layer (nm) | 15 | 16 | 16 | 6 |
| | 3 | High refractive index layer (nm) | 45 | 45 | 45 | 70 |
| | 2 | Low refractive index layer (nm) | 40 | 43 | 43 | 33 |
| | 1 | High refractive index layer (nm) | 5 | 5 | 6 | 8 |
| Barrier layer | | SiN (nm) | 9 | 9 | 9 | 9 |
| Substrate | | | Anti-glare PET film/transparent adhesive/glass | Anti-glare PET film/transparent adhesive/glass | Anti-glare PET film/transparent adhesive/glass | Anti-glare TAC film/transparent adhesive/glass |
| SCI (D65) | | Luminous reflectance Y (%) | 0.56 | 0.51 | 0.49 | 0.28 |
| | | a* | 1.5 | 0.0 | 0.5 | -0.7 |
| | | b* | -1.9 | -1.8 | -3.9 | -0.2 |

(continued)

| | Angle with respect to specularly reflected light | Example 1 | | | Example 2 | | | Example 3 | | | Example 4 | | |
|---|---|---|---|---|---|---|---|---|---|---|---|---|---|
| | | L* | *a | b* | L* | *a | b* | L* | * a | b* | L* | a* | b* |
| Diffusion reflection color (D65) | -15° | 52.8 | 2.0 | 7.9 | 50.7 | 2.2 | 6.0 | 49.3 | 3.3 | 6.2 | 23.6 | 0.4 | 2.7 |
| | 15° | 23.9 | 1.5 | 3.3 | 22.1 | -0.2 | 2.9 | 20.6 | 2.6 | -1.2 | 6.6 | 0.7 | 1.3 |
| | 25° | 10.8 | 1.3 | 0.6 | 9.3 | -0.6 | 0.7 | 8.2 | 2.0 | -3.6 | 0.5 | 0.1 | 0.0 |
| | 45° | 2.1 | 0.5 | -0.9 | 1.7 | 0.0 | -0.9 | 1.5 | 0.4 | -1.9 | 0.1 | 0.0 | 0.0 |
| | 75° | 0.6 | 0.3 | -0.4 | 0.5 | 0.3 | -0.4 | 0.5 | 0.3 | -0.6 | 0.1 | 0.0 | 0.0 |
| | 110° | 1.2 | 1.0 | -0.1 | 0.7 | 0.5 | 0.1 | 0.6 | 0.5 | 0.1 | 0.1 | 0.0 | 0.0 |
| Color deviation evaluation | | A | | | A | | | A | | | A | | |

[Table 2]

| | | | Example 5 | Example 6 | Example 7 | Example 8 | Example 9 |
|---|---|---|---|---|---|---|---|
| Number of layers in anti-reflection film | | | 4 | 6 | 6 | 4 | 6 |
| Luminous transmittance Y (D65) (%) | | | 75 | 75 | 94 | 94 | 75 |
| b* of transmission color under D65 light source | | | 1.1 | 1.8 | 0.1 | 0.3 | 1.8 |
| Transmission haze (%) | | | 60 | 60 | 60 | 60 | 60 |
| High refractive index layer | | | NMWO | NMWO | $Nb_2O_5$ | $TiO_2$ | NMWO |
| Diffusion reflection color | | | green, blue, and red | green and blue | black | red and purple | green and blue |
| Antifouling film | | KY-185 (nm) | 4 | 4 | 4 | 4 | 4 |
| Anti-reflection film | 6 | Low refractive index layer (nm) | - | 80 | 94 | - | 86 |
| | 5 | High refractive index layer (nm) | - | 39 | 39 | - | 51 |
| | 4 | Low refractive index layer (nm) | 81 | 5 | 18 | 90 | 10 |
| | 3 | High refractive index layer (nm) | 110 | 60 | 43 | 105 | 55 |
| | 2 | Low refractive index layer (nm) | 33 | 29 | 38 | 34 | 42 |
| | 1 | High refractive index layer (nm) | 4 | 5 | 5 | 4 | 6 |
| Barrier layer | | SiN (nm) | 15 | 15 | 10 | 12 | 9 |
| Substrate | | | Anti-glare PET film/-transparent adhesive/-glass | Anti-glare PET film/-transparent adhesive/-glass | Anti-glare PET film/-transparent adhesive/-glass | Anti-glare PET film/-transparent adhesive/-glass | Anti-glare PET film/-transparent adhesive/-glass |
| SCI (D65) | | Luminous reflectance Y (%) | 0.65 | 0.70 | 0.99 | 0.93 | 0.31 |
| | | a* | 0.2 | -1.4 | -0.7 | 2.8 | -0.4 |
| | | b* | -3.1 | -1.3 | -1.5 | -4.5 | 0.0 |

(continued)

| | Angle with respect to specularly reflected light | Example 5 | | | Example 6 | | | Example 7 | | | Example 8 | | | Example 9 | | |
|---|---|---|---|---|---|---|---|---|---|---|---|---|---|---|---|---|
| | | L* | * a | b* | L* | * a | b* | L* | a* | b* | L* | a* | b* | L* | * a | b* |
| Diffusion reflection color (D65) | -15° | 50.2 | -0.3 | 5.0 | 52.1 | 0.6 | 2.9 | 54.3 | -2.9 | 6.5 | 51.5 | 5.3 | 2.5 | 52.7 | -4.1 | 6.3 |
| | 15° | 23.3 | -2.5 | 2.5 | 25.0 | -3.5 | 1.8 | 28.1 | -3.6 | 3.5 | 24.9 | 5.1 | -3.3 | 23.4 | -4.5 | 11.0 |
| | 25° | 10.0 | -2.5 | 0.4 | 11.5 | -3.7 | -0.7 | 13.2 | -3.4 | 2.3 | 10.5 | 5.4 | -3.8 | 4.0 | -1.4 | 2.9 |
| | 45° | 2.2 | -0.6 | -1.0 | 2.5 | -1.0 | -2.5 | 3.0 | -1.0 | -0.6 | 3.2 | 1.8 | -1.3 | 0.1 | 0.0 | 0.0 |
| | 75° | 0.9 | 0.4 | -0.8 | 0.9 | 0.3 | -1.4 | 1.2 | 0.1 | -0.8 | 2.1 | 1.0 | -0.7 | 0.1 | 0.0 | 0.0 |
| | 110° | 1.2 | 1.0 | -0.1 | 1.0 | 0.9 | -0.4 | 1.7 | 0.7 | -0.6 | 3.2 | 1.3 | -0.1 | 0.2 | 0.0 | 0.1 |
| Color deviation evaluation | | C | | | C | | | B | | | B | | | B | | |

[Table 3]

| | | | Example 10 | | | Example 11 | | |
|---|---|---|---|---|---|---|---|---|
| Number of layers in anti-reflection film | | | 6 | | | 6 | | |
| Luminous transmittance Y (D65) (%) | | | 88.3 | | | 61.1 | | |
| b* of transmission color under D65 light source | | | 0.3 | | | 1.7 | | |
| Transmission haze (%) | | | 56 | | | 57 | | |
| High refractive index layer | | | NMWO | | | NMWO | | |
| Diffusion reflection color | | | blue and yellow | | | blue and yellow | | |
| Antifouling film | | KY-185 (nm) | 4 | | | 4 | | |
| Anti-re-flection film | 6 | Low refractive index layer (nm) | 85 | | | 85 | | |
| | 5 | High refractive index layer (nm) | 50 | | | 42 | | |
| | 4 | Low refractive index layer (nm) | 5 | | | 13 | | |
| | 3 | High refractive index layer (nm) | 59 | | | 50 | | |
| | 2 | Low refractive index layer (nm) | 34 | | | 39 | | |
| | 1 | High refractive index layer (nm) | 8 | | | 7 | | |
| Barrier layer | | SiN (nm) | 9 | | | 9 | | |
| Substrate | | | Anti-glare PET film/transparent adhesive/glass | | | Anti-glare PET film/transparent adhesive/glass | | |
| SCI (D65) | | Luminous reflectance Y (%) | 0.79 | | | 0.52 | | |
| | | a* | 1.2 | | | 0.7 | | |
| | | b* | -3.6 | | | -2.7 | | |
| Diffusion reflection color (D65) | | Angle with respect to specularly reflected light | L* | * a | b* | L* | * a | b* |
| | | -15° | 52.0 | -1.0 | 6.2 | 52.8 | 1.4 | 11.4 |
| | | 15° | 25.0 | 0.5 | 0.3 | 23.4 | 2.2 | 8.2 |
| | | 25° | 8.6 | 1.1 | -2.2 | 9.7 | 2.0 | 5.2 |
| | | 45° | 1.3 | 0.4 | -1.6 | 1.6 | 0.5 | 0.3 |
| | | 75° | 0.6 | 0.2 | -0.5 | 0.5 | 0.2 | -0.1 |
| | | 110° | 0.9 | 0.4 | -0.2 | 0.6 | 0.3 | 0.1 |
| Color deviation evaluation | | | A | | | A | | |

From the results of Tables 1 to 3, it was confirmed that, in Examples 1 to 4, Example 10, and Example 11, which are inventive examples, it was possible to significantly suppress color variation after tiling.

Although the present invention has been described in detail with reference to specific embodiments, it is apparent to those skilled in the art that various changes and modifications can be made without departing from the spirit and scope of the present invention. The present application is based on Japanese Patent Application No. 2023-091871 filed on June 2, 2023, the contents of which are incorporated herein by reference.

REFERENCE SIGNS LIST

1 Anti-reflection film-attached transparent substrate
10 Transparent substrate
11 One main surface
12 The other main surface
20 Black tape
30 Anti-reflection film
31 Diffusion layer
32 First dielectric layer
34 Second dielectric layer
50 Light source
60 Incident light
61 Specularly reflected light
71, 72, 73, 74, 75, 76 Diffusely reflected light

**Claims**

1. An anti-reflection film-attached transparent substrate comprising: a transparent substrate comprising two main surfaces; and a diffusion layer and an anti-reflection film in this order from a transparent substrate side on one main surface of the transparent substrate,
   wherein when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1) and (2):

$$(1) \ -2 \leq a^* \leq 4.5$$

$$(2) \ -5 \leq b^* \leq 10.$$

2. An anti-reflection film-attached transparent substrate comprising: a transparent substrate comprising two main surfaces; and a diffusion layer and an anti-reflection film in this order from a transparent substrate side on one main surface of the transparent substrate,
   wherein when a light source is incident on the one main surface side at an incident angle of 45° in a state where reflection on the other main surface of the transparent substrate is removed, a* and b* of diffusely reflected light at each angle of -15°, 15°, 25°, 45°, 75°, and 110° with respect to specularly reflected light under a D65 light source satisfy the following expressions (1') and (2'):

$$(1') \ -2 \leq a^* \leq 4.5$$

$$(2') \ -3 \leq b^* \leq 13.$$

3. The anti-reflection film-attached transparent substrate according to claim 1 or 2, wherein a luminous reflectance (SCI Y) on an outermost surface is 1.2% or less.

4. The anti-reflection film-attached transparent substrate according to claim 1 or 2, wherein a* and b* of SCI on an outermost surface satisfy the following expressions (3) and (4):

$$(3) \ -1 \leq a^* \leq 2$$

$$(4) \ -5 \leq b^* \leq 0.$$

5. The anti-reflection film-attached transparent substrate according to claim 1 or 2, having a haze value of 25% or more.

6. The anti-reflection film-attached transparent substrate according to claim 1 or 2, wherein L* of the diffusely reflected light in 15° under a D65 light source is 5 to 35, and L* of the diffusely reflected light in 25° is 0 to 20.

7. The anti-reflection film-attached transparent substrate according to claim 1 or 2, wherein a luminous transmittance (Y) is 20% to 96%.

8. The anti-reflection film-attached transparent substrate according to claim 1 or 2, wherein the anti-reflection film has a sheet resistance of $10^4$ $\Omega/\square$ or more.

9. The anti-reflection film-attached transparent substrate according to claim 1 or 2, wherein b* of a transmission color under a D65 light source is 5 or less.

10. The anti-reflection film-attached transparent substrate according to claim 1 or 2,

wherein the anti-reflection film has a laminated structure in which at least two dielectric layers having refractive indices different from each other are laminated,
at least one layer of the dielectric layers is mainly composed of an oxide of Si,
at least another layer among layers of the laminated structure is mainly composed of a mixed oxide of an oxide containing at least one selected from the group A consisting of Mo and W and an oxide containing at least one selected from the group B consisting of Si, Nb, Ti, Zr, Ta, Al, Sn and In, and
a content of elements of the group B contained in the mixed oxide is 65 mass% or less with respect to a total of elements of the group A contained in the mixed oxide and the elements of the group B contained in the mixed oxide.

11. The anti-reflection film-attached transparent substrate according to claim 1 or 2, further comprising an antifouling film on the anti-reflection film.

12. The anti-reflection film-attached transparent substrate according to claim 1 or 2, wherein the transparent substrate comprises a glass.

13. The anti-reflection film-attached transparent substrate according to claim 1 or 2, wherein the transparent substrate comprises at least one resin selected from polyethylene terephthalate, polycarbonate, acrylic, silicone, and a triacetylcellulose resin film.

14. The anti-reflection film-attached transparent substrate according to claim 1 or 2, wherein the transparent substrate is a laminate of a glass and at least one resin selected from polyethylene terephthalate, polycarbonate, acrylic, silicone, and a triacetylcellulose resin film.

15. The anti-reflection film-attached transparent substrate according to claim 14, wherein the glass is chemically strengthened.

16. An image display device comprising the anti-reflection film-attached transparent substrate according to claim 1 or 2.

FIG. 1

FIG. 2

## FIG. 3

Example 1

## FIG. 4

# FIG. 5

Example 3

## FIG. 6

Example 4

*FIG. 7*

*FIG. 8*

Example 6

*FIG. 9*

— Example 7

*FIG. 10*

## FIG. 11

Example 9

## FIG. 12

Example 10

*FIG. 13*

—●— Example 11

FIG. 14

## INTERNATIONAL SEARCH REPORT

| International application No. |
| --- |
| **PCT/JP2024/019817** |

**A. CLASSIFICATION OF SUBJECT MATTER**

*C03C 17/34*(2006.01)i; *B32B 7/023*(2019.01)i; *C03C 21/00*(2006.01)i; *G02B 1/18*(2015.01)i; *G02B 1/115*(2015.01)i; *G02B 5/02*(2006.01)i

FI: C03C17/34 Z; C03C21/00 101; G02B1/18; G02B1/115; G02B5/02 B; B32B7/023

According to International Patent Classification (IPC) or to both national classification and IPC

**B. FIELDS SEARCHED**

Minimum documentation searched (classification system followed by classification symbols)

C03C17/00-17/44; B32B7/023; G02B1/115; G02B5/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2018-536177 A (CORNING INC.) 06 December 2018 (2018-12-06) | 1-16 |
| A | JP 2021-510362 A (CORNING INC.) 22 April 2021 (2021-04-22) | 1-16 |
| A | JP 2021-144201 A (NITTO DENKO CORP.) 24 September 2021 (2021-09-24) | 1-16 |
| A | JP 2018-115105 A (ASAHI GLASS COMPANY, LIMITED) 26 July 2018 (2018-07-26) | 1-16 |
| P, A | WO 2023/195498 A1 (AGC INC.) 12 October 2023 (2023-10-12) | 1-16 |

☐ Further documents are listed in the continuation of Box C.　　☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **17 July 2024** | **06 August 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

# EP 4 722 175 A1

## INTERNATIONAL SEARCH REPORT
### Information on patent family members

International application No.

**PCT/JP2024/019817**

| Patent document cited in search report | | | Publication date (day/month/year) | Patent family member(s) | | | Publication date (day/month/year) |
|---|---|---|---|---|---|---|---|
| JP | 2018-536177 | A | 06 December 2018 | US | 2017/0075039 | A1 | |
| | | | | WO | 2017/048700 | A1 | |
| | | | | EP | 3300520 | A1 | |
| | | | | CN | 107735697 | A | |
| | | | | KR | 10-2018-0052701 | A | |
| JP | 2021-510362 | A | 22 April 2021 | US | 2019/0219739 | A1 | |
| | | | | WO | 2019/139928 | A1 | |
| | | | | EP | 3737652 | A1 | |
| | | | | KR | 10-2020-0107999 | A | |
| | | | | CN | 111788161 | A | |
| JP | 2021-144201 | A | 24 September 2021 | CN | 113391380 | A | |
| | | | | KR | 10-2021-0116284 | A | |
| JP | 2018-115105 | A | 26 July 2018 | US | 2018/0203354 | A1 | |
| | | | | CN | 108312655 | A | |
| WO | 2023/195498 | A1 | 12 October 2023 | WO | 2023/195499 | A1 | |
| | | | | WO | 2023/195500 | A1 | |
| | | | | WO | 2023/195497 | A1 | |
| | | | | WO | 2024/014442 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018115105 A
- JP 2023091871 A